(19) Europäisches Patentamt

European Patent Office

Office européen des brevets

(11) **EP 2 033 282 B1**

## (12) EUROPEAN PATENT SPECIFICATION

(45) Date of publication and mention
of the grant of the patent:
**31.10.2012  Bulletin 2012/44**

(21) Application number: **07848895.4**

(22) Date of filing: **06.06.2007**

(51) Int Cl.:
*H01S 5/026* (2006.01)      *H01S 5/183* (2006.01)
*H01S 5/20* (2006.01)      *H01S 5/028* (2006.01)
*H01S 5/042* (2006.01)      *H01S 5/062* (2006.01)
*H01L 31/00* (2006.01)      *H01L 31/0232* (2006.01)
*H01L 31/103* (2006.01)      *H01L 33/00* (2010.01)
*H01L 33/10* (2010.01)

(86) International application number:
**PCT/IB2007/003510**

(87) International publication number:
**WO 2008/029283 (13.03.2008 Gazette 2008/11)**

(54) **OPTOELECTRONIC DEVICE FOR HIGH-SPEED DATA TRANSFER**

OPTOELEKTRONISCHE VORRICHTUNG ZUR
HOCHGESCHWINDIGKEITSDATENÜBERTRAGUNG

PÉRIPHÉRIQUE OPTO-ÉLECTRONIQUE POUR TRANSFERT DE DONNÉES À HAUTE VITESSE

(84) Designated Contracting States:
**AT BE BG CH CY CZ DE DK EE ES FI FR GB GR
HU IE IS IT LI LT LU LV MC MT NL PL PT RO SE
SI SK TR**

(30) Priority: **16.06.2006   US 453979**
**16.06.2006   US 814054 P**

(43) Date of publication of application:
**11.03.2009   Bulletin 2009/11**

(73) Proprietor: **Russian limited liability company
"Connector Optics"
Saint-Petersburg, 194292 (RU)**

(72) Inventors:
 • **Ledentsov, Nikolai
   10717 Berlin (DE)**
 • **Shchukin, Vitaly
   10717 Berlin (DE)**

(74) Representative: **Siebert, Karsten et al
WSL Patentanwälte
Kaiser-Friedrich-Ring 98
65185 Wiesbaden (DE)**

(56) References cited:
EP-A- 0 618 651        WO-A-99/57789
US-A1- 2002 074 555     US-A1- 2005 002 604
US-A1- 2005 117 623     US-B2- 6 611 539
US-B2- 6 865 214       US-B2- 7 031 360

 • JIHE LV ET AL: "Monothically Integrated Long-Wavelength Tunable Photodetector" JOURNAL OF LIGHTWAVE TECHNOLOGY, IEEE SERVICE CENTER, NEW YORK, NY, US, vol. 26, no. 3, 1 February 2008 (2008-02-01), pages 338-342, XP011204237 ISSN: 0733-8724
 • KHAN A ET AL: "Voltage-controlled distributed Bragg reflectors for modulation and integrated power monitoring of vertical-cavity surface-emitting lasers" ELECTRONICS LETTERS, IEE STEVENAGE, GB, vol. 30, no. 25, 8 December 1994 (1994-12-08), pages 2146-2147, XP006001475 ISSN: 0013-5194

Remarks:
The file contains technical information submitted after the application was filed and not included in this specification

EP 2 033 282 B1

**Description**

REFERENCE TO RELATED APPLICATIONS

This application claims an invention which was disclosed in United States Utility Patent Application Number US 11/453,979, filed June 16, 2006, entitled "ELECTROOPTICALLY BRAGG-REFLECTOR STOPBAND-TUNABLE OPTOELECTRONIC DEVICE FOR HIGH-SPEED DATA TRANSFER" and United States Provisional Patent Application Number US60/814,054, filed June 16, 2006, entitled "RESONANT CAVITY OPTOELECTRONIC DEVICE WITH SUPPRESSED PARASITIC MODES".

BACKGROUND OF THE INVENTION

FIELD OF THE INVENTION

The invention pertains to the field of semiconductor devices. More particularly, the invention pertains to ultrahigh-speed optoelectronic devices, such as light-emitting diodes and laser diodes

DESCRIPTION OF RELATED ART

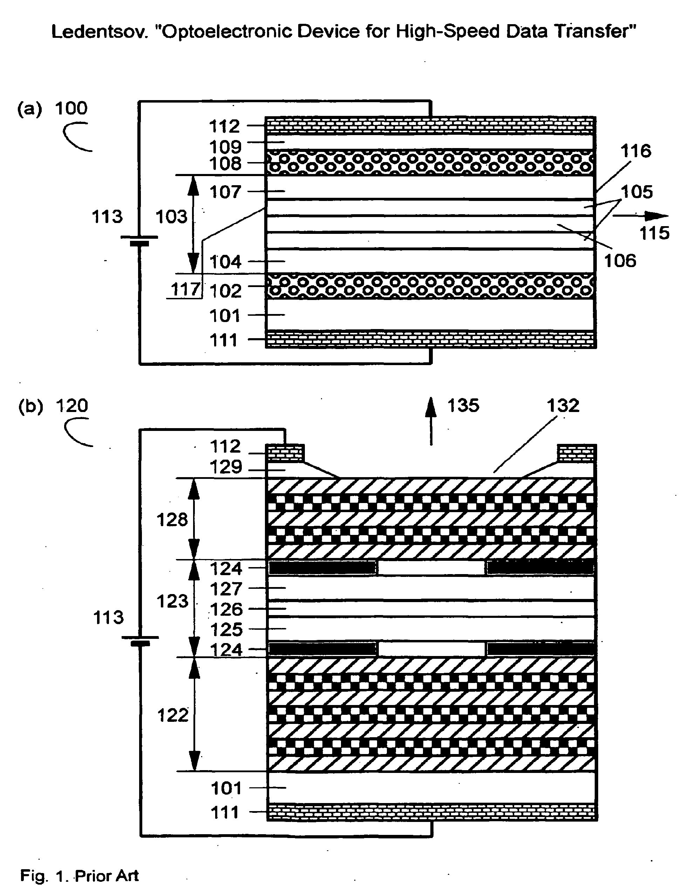

High-speed optoelectronic devices are broadly applied in modem datacommunication and telecommunication systems.
These devices can be separated into two categories: those directly modulated by injection of current into the gain region, and those externally modulated. Direct modulation offers the advantage of low cost.
Prior art optoelectronic device, namely, an edge-emitting laser, is shown schematically in Fig. 1(a). The active region is placed in a waveguide region sandwiched by the two layers having a lower refractive index and providing total internal reflection for the waveguiding mode. The device includes a substrate, a buffer layer, bottom cladding layer a waveguide layer with the active medium inserted, a top cladding layer, contact layer and metal contacts.
The laser structure (100) is grown epitaxially on an n-doped substrate (101). The structure further includes an n-doped cladding layer (102), a waveguide (103), a p-doped cladding layer (108), and a p-contact layer (109). The waveguide (103) includes an n-doped layer (104), a confinement layer (105) with an active region (106) inside the confinement layer, and a p-doped layer (107). The n-contact (111) is contiguous with the substrate (101). A p-contact (112) is mounted on the p-contact layer (109). The active region (106) generates light when a forward bias (113) is applied. The profile of the optical mode in the vertical direction z is determined by the refractive index profile in the z-direction. The refractive index of the waveguide (103) is preferably higher than the refractive index of the n-doped cladding layer (102) and of the p-doped cladding layer (108). The refractive index profile preferably ensures a single optical mode confined within the waveguide (103). Light in the optical mode undergoes the total internal reflection of the boundary between the waveguide (103) and the n-doped cladding layer (102) and on the boundary between the waveguide (103) and the p-doped cladding layer (108). Thus, light emitted in the optical mode confined in the waveguide (103) and propagates along the waveguide (103).
The waveguide (103) is bounded in the lateral plane by a front facet (116) and a rear facet (117). Light propagating in the confined optical mode can come out through the front facet (116) and through the rear facet (117). If a special highly reflecting coating is put on the rear facet (117), the laser light (115) is emitted only through the front facet (116).
The substrate (101) is formed from any III-V semiconductor material or III-V semiconductor alloy. For example, GaAs, InP, GaSb, GaP or InP are generally used depending on the desired emitted wavelength of laser radiation. Alternatively, sapphire, SiC or [111]-Si is used as a substrate for GaN-based lasers, i.e. laser structures, the layers of which are formed of GaN, AIN, InN, or alloys of these materials. The substrate (101) is doped by an n-type, or donor impurity. Possible donor impurities include, but are not limited to S, Se, Te, and amphoteric impurities like Si, Ge, Sn, where the latter are introduced under such technological conditions that they are incorporated predominantly into the cation sublattice to serve as donor impurities.
The n-doped cladding layer (102) is formed from a material lattice-matched or nearly lattice-matched to the substrate (101), is transparent to the generated light, and is doped by a donor impurity. In the case of a GaAs substrate (101), the n-doped cladding layer is preferably formed of a GaAlAs alloy.
The n-doped layer (104) of the waveguide (103) is formed from a material lattice-matched or nearly lattice-matched to the substrate (101), is transparent to the generated light, and is doped by a donor impurity. In the case of a GaAs substrate, the n-doped layer (104) of the waveguide is preferably formed of GaAs or of a GaAlAs, alloy having an Al content lower than that in the n-doped cladding layer (102).
The p-doped layer (107) of the waveguide (103) is formed from a material lattice-matched or nearly lattice-matched to the substrate (101), is transparent to the generated light, and is doped by an acceptor impurity. Preferably, the p-doped layer (107) of the waveguide is formed from the same material as the n-doped layer (104) but doped by an acceptor impurity. Possible acceptor impurities include, but are not limited to, Be, Mg, Zn, Cd, Pb, Mn and amphoteric impurities like Si, Ge, Sn, where the latter are introduced under such technological conditions that they are incorporated predominantly into the anion sublattice and serve as acceptor impurities.

The p-doped cladding layer (108) is formed from a material lattice-matched or nearly lattice-matched to the substrate (101), transparent to the generated light, and doped by an acceptor impurity. Preferably, the p-doped cladding layer (108) is formed from the same material as the n-doped cladding layer (102), but is doped by an acceptor impurity.

The p-contact layer (109) is preferably formed from a material lattice-matched or nearly lattice matched to the substrate, is transparent to the generated light, and is doped by an acceptor impurity. The doping level is preferably higher than that in the p-cladding layer (108).

The metal contacts (111) and (112) are preferably formed from the multi-layered metal structures. The metal contact (111) is preferably formed from a structure including, but not limited to the structure Ni-Au-Ge. Metal contacts (112) are preferably formed from a structure including, but not limited to, the structure Ti-Pt-Au.

The confinement layer (105) is formed from a material lattice-matched or nearly lattice-matched to the substrate (101), is transparent to the generated light, and is either undoped or weakly doped. The confinement layers are preferably formed from the same material as the substrate (101).

The active region (106) placed within the confinement layer (105) is preferably formed by any insertion, the energy band gap of which is narrower than that of the energy band gap of the bottom cladding layer (102), of the n-doped layer (104) of the waveguide (103), of the confinement layer (105) of the waveguide (103), of the p-doped layer (107) of the waveguide (103), and of the top cladding layer (108). Possible active regions (106) include, but are not limited to, a single-layer or a multi-layer system of quantum wells, quantum wires, quantum dots, or any combination thereof. In the case of a device on a GaAs-substrate, examples of the active region (106) include, but are not limited to, a system of insertions of InAs, $In_{1-x}Ga_xAs$, $In_xGa_{1-x-y}Al_yAs$, $In_xGa_{1-x}As_{1-y}N_y$ or similar materials.

Edge-emitting laser can be applied, in principle, for data transfer using direct modulation.

Direct modulation of light can also be realized by vertical cavity surface emitting lasers (VCSELs). Figure 1(b) shows a schematic diagram of a prior art VCSEL. The active region is placed in a vertical cavity region clad by two multilayer interference reflectors; most often, distributed Bragg reflectors. The device includes a substrate, a buffer layer, a first distributed Bragg reflector, a cavity, a second distributed Bragg reflector.

In the prior art VCSEL (120) in Fig. 1(b) the active region (126) is put into a cavity (123), which is sandwiched between an n-doped bottom mirror (122) and a p-doped top mirror (128). The cavity (123) includes an n-doped layer (125), an undoped active element including active region (126), and a p-doped layer (127). Oxide apertures (124) are preferably introduced to define the current path. Bragg reflectors each including a periodic sequence of alternating layers having low and high refractive indices are used as a bottom mirror (122) and a top mirror (128). The cavity (123) acts as a light generating element. Light is generated by the active region (126) inside the cavity (123) when a forward bias (113) is applied. Light comes out (135) through the optical aperture (132). The wavelength of the emitted laser light from the VCSEL is determined by the length of the cavity (123).

The layers forming the bottom mirror (122) are formed from materials lattice-matched or nearly lattice matched to the substrate (101), are transparent to the generated light, are doped by a donor impurity, and have alternating high and low refractive indices. For a VCSEL grown on a GaAs substrate, alternating layers of GaAs and GaAlAs or layers of GaAlAs having alternating aluminum content preferably form the mirror (122).

The n-doped layer (125) of the cavity (123) is formed from a material lattice-matched or nearly lattice-matched to the substrate (101), is transparent to the generated light, and is doped by a donor impurity.

The p-doped layer (127) of the cavity (123) is formed from a material lattice-matched or nearly lattice-matched to the substrate (101), is transparent to the generated light, and is doped by an acceptor impurity.

The layers forming the top mirror (128) are formed from materials lattice-matched or nearly lattice-matched to the substrate (101), are transparent to the generated light, are doped by an acceptor impurity, and have alternating high and low refractive indices. For a VCSEL grown on a GaAs substrate, alternating layers of GaAs and GaAlAs or layers of GaAlAs having alternating aluminum content preferably form the mirror (128).

The p-contact layer (129) is formed from a material doped by an acceptor impurity. For a VCSEL grown on a GaAs substrate, the preferred material is GaAs. The doping level is preferably higher than that in the top mirror (128). The p-contact layer (129) and the metal p-contact (112) are etched to form an optical aperture (132).

The active region (126) placed within the cavity (123) is preferably formed by any insertion, the energy band gap of which is narrower than that of the bottom mirror (122), of the n-doped layer (125) of the cavity (123), of the p-doped layer (127) of the cavity (123), and of the top mirror (128). Possible active regions (126) include, but are not limited to, a single-layer or a multi-layer system of quantum wells, quantum wires, quantum dots, or any combination thereof. In the case of a device on a GaAs-substrate, examples of the active region (126) include, but are not limited to, a system of insertions of InAs, $In_{1-x}Ga_xAs$, $In_xGa_{1-x-y}Al_yAs$, $In_xGa_{1-xA}s_{1-y}N_y$ or similar materials.

The active region (126) generates optical gain when a forward bias (113) is applied. The active region (126) then emits light, which is bounced between the bottom mirror (122) and the top mirror (128). The mirrors have high reflectivity for light propagating in the normal direction to the p-n junction plane, and the reflectivity of the bottom mirror (122) is higher than that of the top mirror (128). Thus, the VCSEL design provides a positive feedback for light propagating in the vertical direction and finally results in lasing. The laser light (135) comes out through the optical aperture (132).

One can note several disadvantages of using VCSELs as the source of light for direct modulation. The first problem is related to a large number of parasitic modes which exist apart from the vertical optical mode desired for the light emission. Similarly to the case of edge-emitting laser, these parasitic modes slow down the operation of a VCSEL.

Second, high-speed direct modulation of a laser requires very high photon densities in the resonant cavity. The intrinsic speed is defined by the so-called "-3dB" bandwidth, which is roughly proportional to the relaxation-oscillation frequency:

$$f_r = \frac{1}{2\pi} \sqrt{\frac{g_n p_0}{\tau_p}} \, , \qquad\qquad (1)$$

where $g_n$ denotes the differential gain, $p_0$ is the average photon density in the cavity, and $\tau_p$ is the cavity photon lifetime.

A first way to increase the laser bandwidth is to increase the pump current density thereby increasing the photon population of the cavity, for example, by reducing the surface area of the device for the same total current. Under pulsed excitation relaxation, an oscillation frequency as high as 70 GHz has been demonstrated in a pulsed regime at room temperature under applied voltage of 15 Volts. The problem for direct modulation is the overheating of the active region in the continuous wave regime and the related saturation of the differential gain with current and the related saturation of the relaxation oscillation frequency. Another challenge for direct modulation is degradation stability of the device. At the very high current densities the degradation rate may be unacceptably high.

Another big problem of direct modulation is a high differential capacitance of the device under forward bias. The injected carriers reduce the effective thickness of the undoped layer in the p-n-junction and increase the capacitance. Thus, realization of ultrahigh-speed VCSELs is challenging. Similar problems arise for the direct modulation by using edge-emitting lasers.

Yet another possibility to achieve direct modulation of light is realized by a tilted cavity laser, invented by the inventors of the present invention in the US patent 7,031,360 "TILTED CAVITY SEMICONDUCTOR LASER (TCSL) AND METHOD OF MAKING SAME", filed February 12, 2002, issued August 18, 2006, and in the US Patent Application 10/943044 "TILTED CAVITY SEMICONDUCTOR OPTOELECTRONIC DEVICE AND METHOD OF MAKING SAME, filed September 16, 2004.

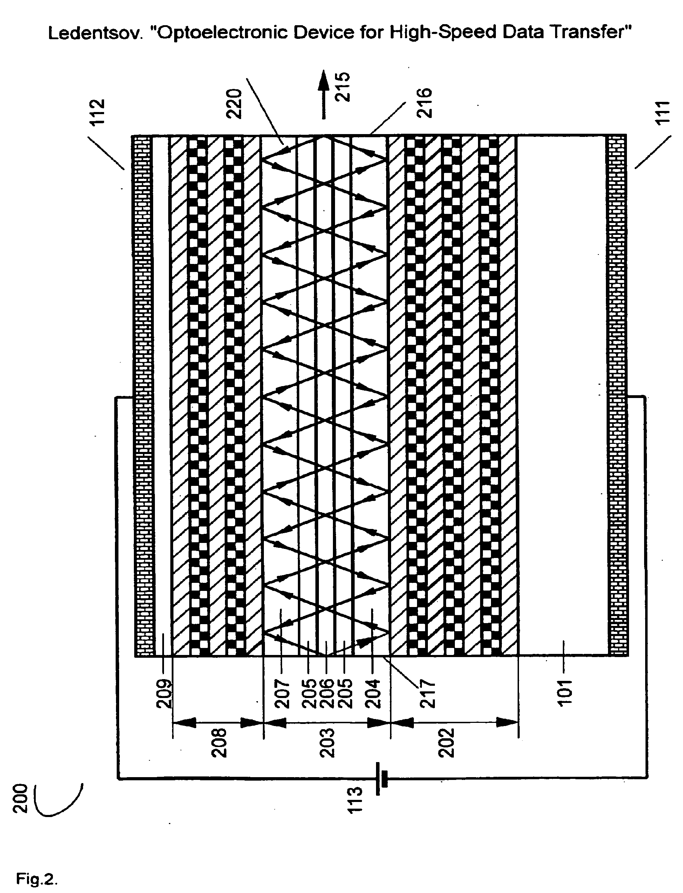

The tilted cavity laser (200) shown schematically in Fig. 2 is grown epitaxially on an n-doped substrate (101) and includes an n-doped bottom multilayered interference reflector (MIR) (202), a cavity (203), a p-doped top multilayered interference reflector (208), and a p-contact layer (209). The cavity (203) includes an n-doped layer (204), a confinement layer (205), and a p-doped layer (207). The confinement layer (205) further includes an active region (206). The laser structure (200) is bounded in the lateral plane by a rear facet (217) and a front facet (216). The cavity (203) and the multilayered interference reflectors (202) and (208) are designed such that resonant conditions for the cavity and for multilayered interference reflectors are met for only one tilted optical mode (220), the light propagating at a certain tilt angle and having a certain wavelength. If the rear facet (217) is covered by a highly reflecting coating, the output laser light (215) comes out only through the front facet (216). The resonant conditions to determine the optimum tilted optical mode (220) are met as follows. The cavity (203) has a first dispersion relation that defines the wavelength of the tilted optical mode as a function of the tilt angle. Each of the two MIRs, the bottom MIR (202) and the top MIR (208), has a dispersion relations that defines the wavelength of the stopband maximum in the reflectivity spectrum of the MIR for a tilt incidence of light as a function of the tilt angle of incidence. The dispersion relations in the cavity (203), on the one hand, and in the MIRs (202) and (208), on the other hand, are different. These dispersion relations match preferably at one wavelength and, correspondingly, one angle. At this wavelength and this angle, the optical mode confined in the cavity (203) is strongly reflected by the bottom MIR (202) and the top MIR (208) and exhibits a small leakage loss. This wavelength is the optimum wavelength. At wavelengths, different from the optimum wavelength, the dispersion relations do not match any longer, the optical mode, confined in the cavity (203) is only weakly reflected by at least one MIR, either by the bottom MIR (202), or the top MIR (208), or both. Then the optical mode has a large leakage loss to the substrate and/or the contacts. In this case wavelength-stabilized device, or a tilted cavity laser or light-emitting diode is realized. The device may be surface-emitting, edge-emitting or provide an option for near-field outcoupling.

In this approach, minimum loss occurs for only one mode at only one wavelength. However, no suppression of parasitic modes at this wavelength is provided. The device may have many parasitic modes, and only a small part of emission comes to a desirable range of angles unless special design measures are undertaken. Essentially, a tilted cavity laser can be viewed as an edge-emitting laser with wavelength-selective losses controlled by an adjusted multilayer interference reflector. Thus, a special approach to achieve suppression of as much parasitic optical modes as possible (and the related radiative recombination), is needed.

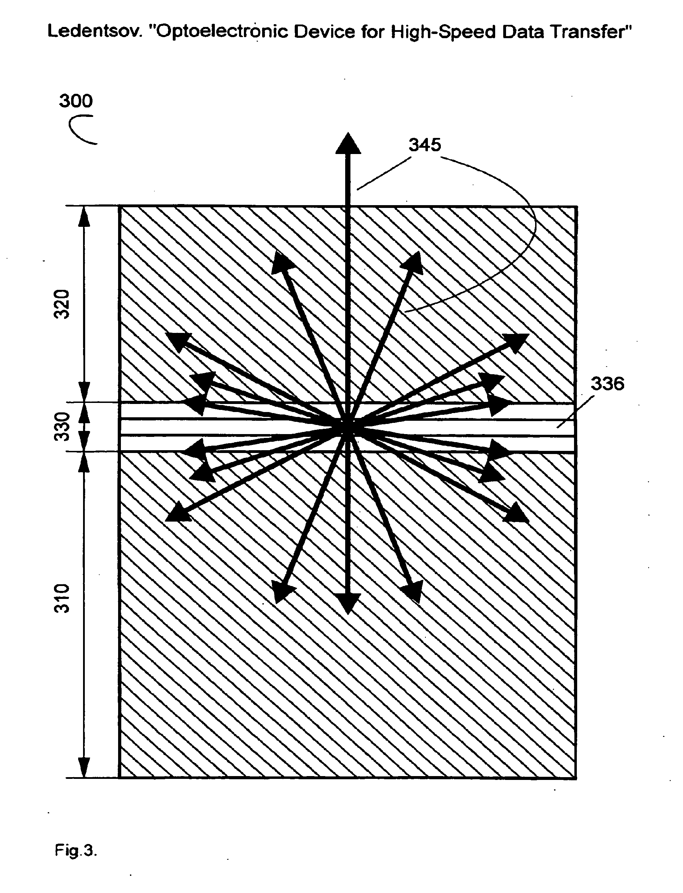

The effective weight of various optical modes and their role in the operation of an optoelectronic device is related to a directional diagram of the emission of light by a given light source. Figure 3 shows schematically a semiconductor structure (300) incorporating a plane (336) of optical oscillators emitting light at a certain photon energy corresponding to a certain wavelength of light $\lambda_0$ in the vacuum. The plane (336) is placed within a cavity (330), which is sandwiched between a first semiconductor material (310) and a second semiconductor material (320). In a practical case, where both the first semiconductor material (310) and the second semiconductor material (320) are the same material, which is optically isotropic, which is the case for GaAs and most of other III-V semiconductor materials, the emission of such oscillators is isotropic and the light propagates (345) in all directions. Whatever is the desired direction of the emission of light, a homogeneous semiconductor medium supports a large number of parasitic modes of the light emission.

In order to reduce the number of parasitic modes, a structured medium is needed. One of existing solutions requires patterning of the surface of a in a 3D pattern preventing the light propagation in a broad range of angles, while selecting only the emission with desirable angle and wavelength. This approach utilizes laterally-processed photonic crystal structures. The disadvantage of this approach is the necessity of etching, which increases costs, reduces heat conductivity and current spreading across the wafer. There is a need in all-epitaxial approaches to solve the problem.

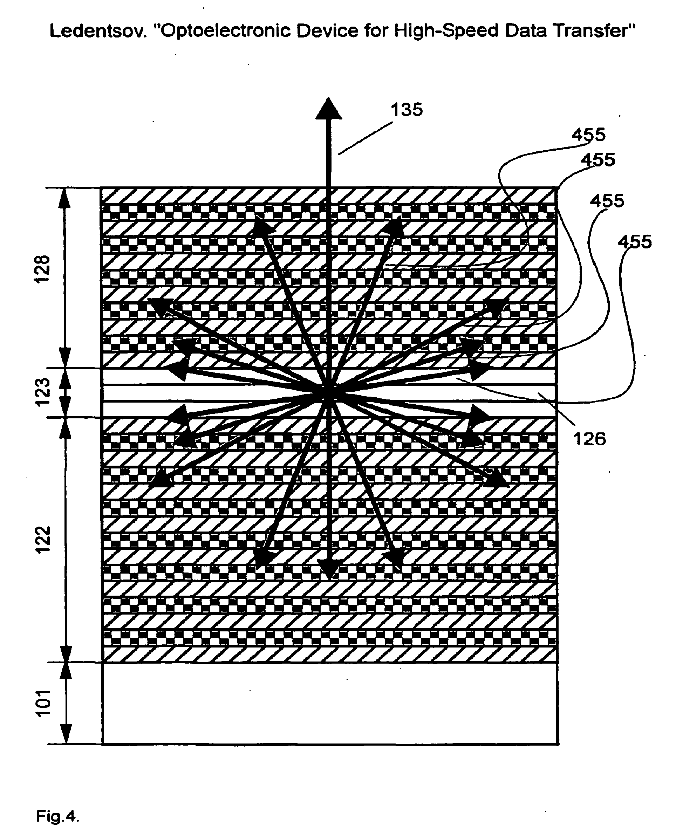

Figure 4 shows a schematic diagram of the emission distribution in the prior art device of Fig. 1(b). Apart of the light emission in the vertical optical mode (135), light is also emitted in many tilted optical modes (455). Thus, there are many radiative modes in a VCSEL and in resonant cavity devices, apart from the useful vertical or quasi-vertical mode.

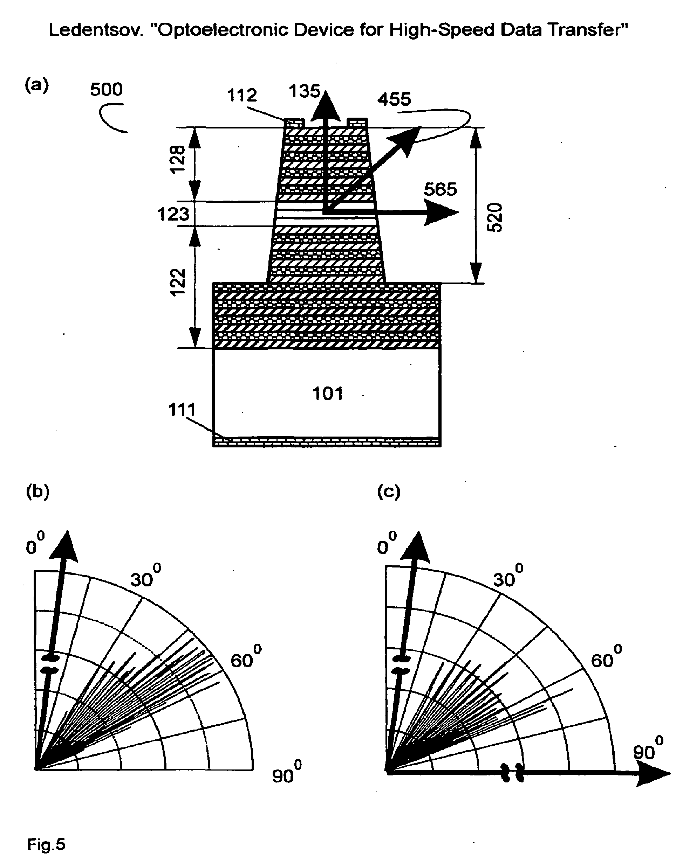

Figure 5(a) shows a schematic diagram of a prior-art device similar to the device (120) of Fig. 1(b) with respect to the three groups of emission. The device (500) is processed in such a way that a mesa (520) is formed, as is preferably fabricated for vertical cavity optoelectronic devices. Emission of light consists of three groups of optical modes: emission in the vertical cavity mode (135), emission in the in-plane waveguiding modes (565), and emission in the tilted modes (455).

The idea to suppress certain most dangerous parasitic modes of the emitted light has earlier been applied for vertical cavity surface emitting lasers having an antiwaveguiding cavity. U.S. Patent Application 11/099360, entitled "OPTOELECTRONIC DEVICE BASED ON AN ANTIWAVEGUIDING CAVITY", filed April 5, 2005, by the inventors of the present invention, discloses a semiconductor optoelectronic device comprising at least one cavity and one multilayered interference reflector. The cavity is designed preferably to possess properties of an antiwaveguiding cavity. The cavity has a lower refractive index as compared to the average refractive indices of the DBRs, thus the fundamental optical mode of the device is not localized in the cavity. No optical modes having a significant overlap with the active medium can propagate in the lateral plane. The existing optical modes are the modes propagating in the vertical direction or in a direction tilted to the vertical direction, such that the tilt angle smaller than the angle of the total internal reflection at the semiconductor-air interface and light in such optical modes can come out of the device through the top surface or the substrate. This design reduces the influence of parasitic optical modes and improves characteristics of optoelectronic devices including vertical cavity surface emitting laser, tilted cavity laser emitting through the top surface or a substrate, vertical or tilted cavity resonant photodetecor, vertical or tilted cavity resonant optical amplifier, light-emitting diode, and others. In this invention the most dangerous modes in vertical cavity surface-emitting lasers (VCSEL), which may propagate in-plane along the oxide aperture, so called whispering gallery modes, which may have a sufficient quality factor to result in significant stimulated emission amplification and the radiative lifetime shortening, are prohibited. The whispering gallery modes, which result from the outer VCSEL mesa boundary, and which have very high quality factor filling the mesa from the outside boundary to $\sim R/n$, where R is the outer mesa radius and $n$ is the effective refractive index of the in-plane waveguide, also affect the device performance and may even cause lasing and self-pulsations if the $\sim R/n$ is within the oxide-confined aperture of the device.

Figure 5(b) shows a schematic diagram of the mode intensity distribution in the device with an anti-waveguiding cavity. One can see that in this design most of the emitted light is directed in the directions tilted with respect to the surface and is lost for lasing. The important issue of Fig. 5(b) is the fact that the parasitic emission is predominantly concentrated in a relatively narrow range of angles, where the mode intensities overlap effectively with the active region.

Figure 5(c) shows a schematic diagram of the mode intensity distribution in the device with a waveguiding cavity. In this case the relevance of the tilted modes is weaker, however, about 35-50% of the emission can be concentrated in the parasitic waveguiding mode, resulting in a lot of problems for the device due to formation of high finesse whispering gallery modes associated with oxide aperture or the outer diameter of the VCSEL mesa. Once population inversion is achieved the radiative recombination rate may be dramatically enhanced, depleting the gain and causing higher current densities to achieve vertical lasing, additional overheating and potentially, self-pulsation of the device and/or noise enhancement.

The anti-waveguiding design of an optoelectronic device still has problems related to the parasitic modes. There are also whispering gallery modes in the lateral plane, associated with the tilted vertical modes, which also can be dangerous. Once these are avoided, the other parasitic modes continue to affect radiative loss and overheating of the device, even on a smaller scale due to the very low quality factor.

Thus, as refers to parasitic modes, there is a need in the art for all-epitaxial approaches which offers further suppression of parasitic modes, as compared to both conventional VCSEL and anti-waveguiding VCSEL structures.

Another problem with the application of directly modulated VCSELs for high speed data transfer, related with the necessity of very high power density, can be overcome, if indirect modulation is applied instead. Indirect modulation using electrooptic effects under reverse bias has long been known in ultrahigh-speed transmitters operating at 40-60 Gb/s. For example, a 40-Gb/s open eye diagram of the electroabsorption modulator after 700-km transmission has been demonstrated.

Once the need for direct modulation is abandoned, ultrahigh-speed signal management becomes much easier. 60-100 GHz pin diode photodetectors using large mesa devices as well as other devices are known in the art.

U.S. Patent No. 6,285,704, "FIELD MODULATED VERTICAL CAVITY SURFACE-EMITTING LASER WITH INTERNAL OPTICAL PLUMPING", issued September 4, 2001, proposes a photopumped VCSEL. This VCSEL may be modulated by using an external electrical field applied perpendicular to the active layer, employing the Stark-effect to deliberately change the bandgap of the active layer and hence move the emission wavelength into and out of resonance with the optical cavity formed between the top and bottom mirrors. The optical output is therefore modulated by the electrical field and not by injected carriers. However, as the active region of the device is under a continuous population inversion condition, applying a reverse bias to change the bandgap may cause dramatic photocurrent, depleting the photopumped active region.

U.S. Patent No. 5,574,738, "MULTI-GIGAHERTZ FREQUENCY-MODULATED VERTICAL-CAVITY SURFACE EMITTING LASER", issued November 12, 1996, discloses a saturable absorber contained within the VCSEL's distributed Bragg reflector, which may itself be adjusted during fabrication or in operation. Under controllable operating conditions, the saturable absorber, strategically sized and placed, forces the VCSEL to self-pulsate (in the GHz-regime) at rates related to the local intensity, absorption, lifetime, and carrier density of the saturable absorber. In one of the embodiments, efficiency of the saturable absorber may be controlled by the quantum-confined Stark effect. Mode-locked operation, however, is usually very sensitive to the conditions of the device operation and exists only in a relatively narrow range of carefully-optimized conditions.

U.S. Patent No. 6,396,083, entitled "OPTICAL SEMICONDUCTOR DEVICE WITH RESONANT CAVITY TUNABLE IN WAVELENGTH, APPLICATIONS TO MODULATION OF LIGHT INTENSITY", issued May 28, 2002, discloses a device including a resonant cavity. The resonant cavity is delimited by two mirrors and at least one super-lattice that is placed in the cavity and is formed from piezoelectric semiconducting layers. The device also includes means of injecting charge carriers into the super-lattice. One disadvantage of this device is the necessity of using piezoelectric materials. The piezoelectric semiconducting layers are epitaxially grown on a $Cd_{0.88}Zn_{0.12}Te$ substrate and include a pattern composed of a layer of $Cd_{0.19}Mg_{0.09}Te$ and a layer $Cd_{0.88}Zn_{0.12}Te$, each 10 nm thick. This pattern is repeated about a hundred times. The device in this patent is a two-terminal device. The separation of carriers in a piezoelectric superlattice causes long depopulation times. Wavelength modulation and intensity modulation are always interconnected in this patent.

An electrooptic modulator based on the quantum confined Stark effect (QCSE) in a VCSEL was disclosed in U.S. Patent No. 6,611,539, "WAVELENGTH-TUNABLE VERTICAL CAVITY SURFACE EMITTING LASER AND METHOD OF MAKING SAME", issued August 26, 2003, by the inventors of the present invention. The device includes active media suitable for providing gain and enabling laser action of the device, and a position-dependent electrooptic modulator region. Applying the voltage to the modulator region results in a wavelength shift of the lasing wavelength. The absorption in the modulator region remains small. The device is especially applicable for ultrahigh-speed data transfer using wavelength-modulation.

U.S. Patent 7,075,954, entitled "INTELLIGENT WAVELENGTH DIVISION MULTIPLEXING SYSTEMS BASED ON ARRAYS OF WAVELENGTH TUNABLE LASERS AND WAVELENGTH TUNABLE RESONANT PHOTODETECTORS", issued July 11, 2006, by the inventors of the present invention, disclosed high-bit rate data transfer systems based on wavelength-to-intensity modulation conversion. In this approach, a wavelength-tunable VCSEL operates in concert with a wavelength-selective photodetector on the receiver side. Modulation of the VCSEL wavelength transforms into the photodetector current modulation.

U.S. Patent Application US11/144482, entitled "ELECTROOPTICALLY WAVELENGTH-TUNABLE RESONANT CAVITY OPTOELECTRONIC DEVICE FOR HIGH-SPEED DATA TRANSFER", filed June 2, 2005, by the inventors of the present invention, disclosed high-bit rate data transfer system based on a device, which contains at least one wavelength-tunable element controlled by an applied voltage and at least two resonant cavities.

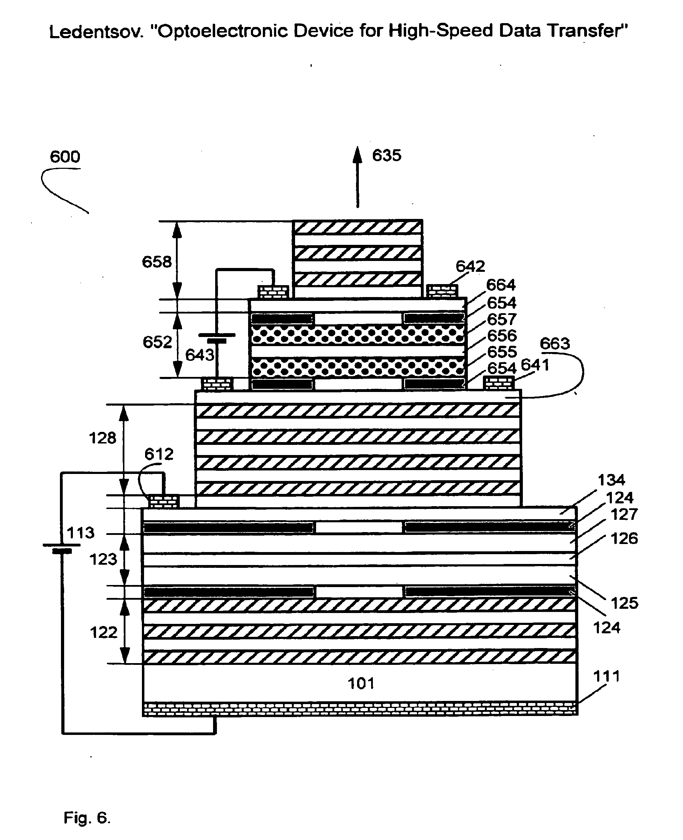

Figure 6 shows a schematic diagram of an electronically intensity-modulated vertical cavity surface emitting laser, invented by the inventor of the present invention (US Patent Application US11/144482). The device (600) includes a wavelength-tunable cavity with a modulating element and a cavity with light generating element. The device (600) includes a substrate (101), which is preferably n-doped, a first distributed Bragg reflector (122), which is preferably n-doped, a light generating element (123), a first current spreading p-layer (134), a second distributed Bragg reflector (128), which is preferably undoped, a second current spreading p-layer (663), a filter element (652), into which a modulator region is introduced, a first current spreading n-layer (664), and a third distributed Bragg reflector (658), which is preferably undoped. The filter element (652) includes a weakly pooped or an undoped layer (655), a modulator region (656), and a weakly n-doped or undoped layer (657). A forward bias (113) is applied to the light generating element (123) via the n-contact (111) and the p-contact (612). A reverse bias (643) is applied to the modulator region (656) via the p-contact (641) and the n-contact, (642). Current apertures (124) are introduced between the first distributed Bragg reflector (122) and the light generating element (123), and between the light generating element (123) and the first current spreading p-layer (134). Current apertures (654) are introduced between the second current spreading p-layer (663) and the filter element (652), and between the filter element (652) and the current spreading n-layer (664). Laser light (635) comes out through the third distributed Bragg reflector (658).

The part of the device, including the substrate (101), the first distributed Bragg reflector (122), the light generating element (123), and the second distributed Bragg reflector (128) is a vertical cavity surface emitting laser. In addition, the device includes a filter element (652).

Layers of the modulator element (652) are preferably formed of any material, lattice-matched or nearly lattice-matched to the substrate and transparent to the generated laser light.

The modulator region (656) includes one or more quantum wells, one or more layers of quantum wires or quantum dots, or any combination thereof. In the particular embodiment of Fig. 6, the modulator operates when a reverse bias (643) is applied.

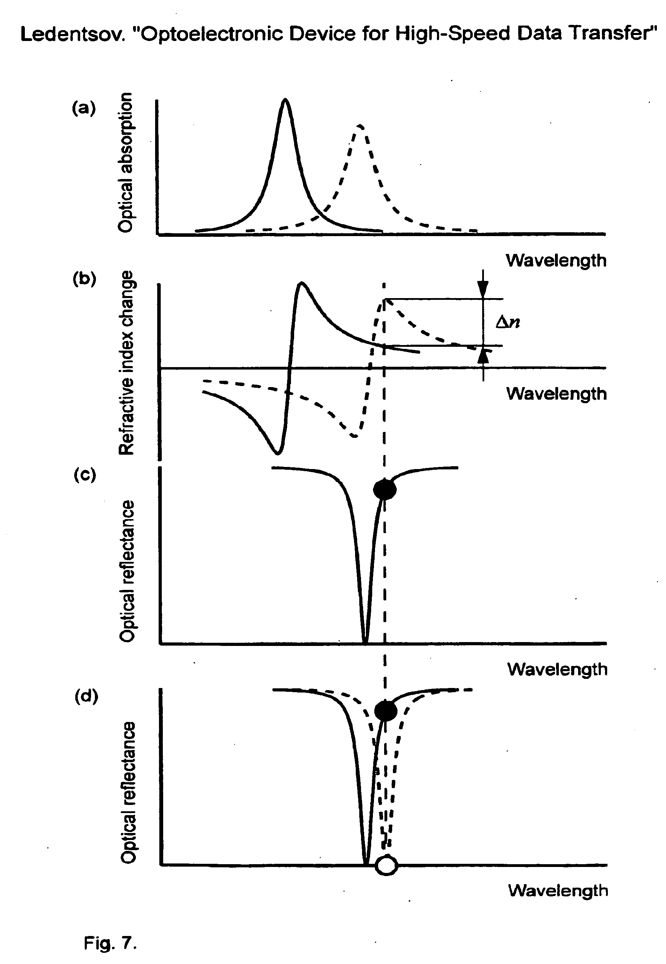

Figure 7 describes schematically the functioning of the modulator element (652) of the device (600) in Fig. 6. The operation of the modulator is based on the quantum confined Stark effect. By varying the bias, the electric field applied to the modulator is varied. Then the position of the optical absorption peak is shifted (The absorption peak shown by a solid line is shifted to a position shown by a dashed like), due to the Stark effect as it is shown in Fig. 7(a). Due to Kramers-Kronig relationship between the real and imaginary parts of the dielectric function of the medium, the shift of the absorption peak results in a modulation of the refractive index of the modulator, as it is shown in Fig. 7(b), where the refractive index curve shown by a solid line is shifted to a position, where it is shown by a dashed line. The latter leads to a shift of the resonant wavelength of the vertical cavity mode reflectivity spectrum from the position depicted in Fig. 7(c) to the position in Fig. 7(d), dashed line. This shift results in matching of the modulator transparency wavelength with the wavelength of the generated laser light and, thus, in a higher output power of the device.

In another realization of the prior art device, the modulator region operates under a forward bias. Applying a forward bias results in the exciton bleaching effect, which further leads to a change in refractive index of the modulator region.

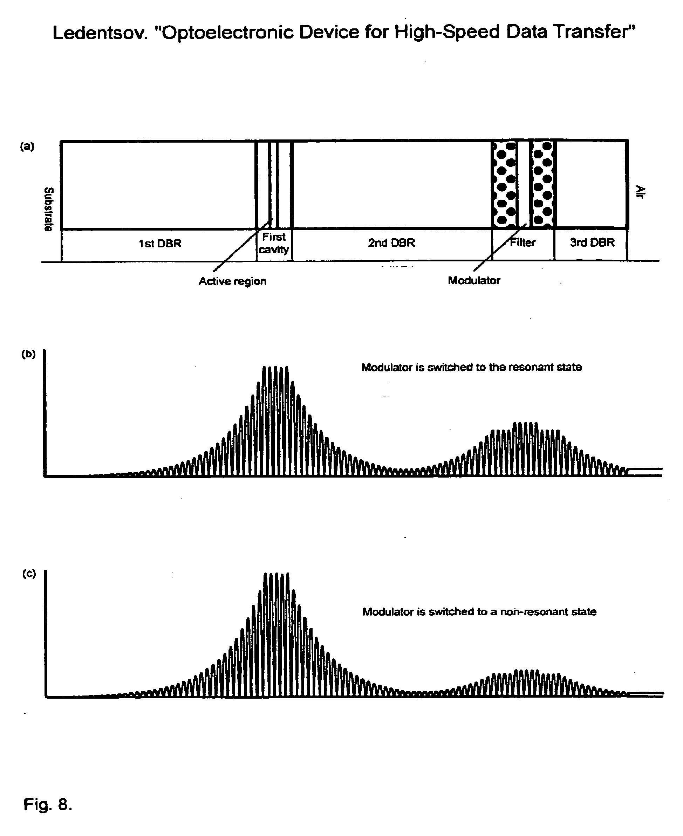

Figure 8 illustrates the principles of the operation of the electronically wavelength tunable vertical cavity surface emitting laser of Fig. 6. Figure 8(a) shows schematically the device of Fig. 6 in a simple form, showing only key elements. The elements shown include the substrate, the first distributed Bragg reflector, the first cavity (which includes the active region), the second distributed Bragg reflector, the electrooptically-modulated filter section, and the third distributed Bragg reflector.

Figure 8(b) shows the spatial profile of the resonant optical mode of the device when the modulator is switched to the resonant state. Figure 8(b) plots the absolute value of the electric field strength in the optical mode. In the resonant state, the laser generates the laser light at a wavelength, which corresponds to the resonant wavelength of the filter. Therefore the resonant optical mode of the laser is a coupled mode having high intensity in both the first cavity and in the filter. Consequently, the light output power proportional to the field intensity in the air is high.

Figure 8(c) shows the spatial profile of the resonant optical mode of the device when the modulator is switched to a non-resonant state. Figure 8(c) plots the absolute value of the electric field strength in the optical mode. In any non-resonant state, the laser generates the laser light at a wavelength other than the resonant wavelength of the filter. Therefore the optical mode of the laser at the non-resonant wavelengths is a mode having a high intensity in the first cavity and a low intensity in the filter. Consequently, the light output power proportional to the field intensity in the air is low.

Alternating a bias voltage applied to the modulator switches the device between the resonant state and some selected non-resonant state. The output light power alternates between a high intensity and a low intensity accordingly.

The resonant wavelength of the tunable element is preferably elecrooptically tuned using the quantum confined Stark effect around the resonant wavelength of the other cavity or cavities, resulting in a modulated transmittance of the system. A light-emitting medium is preferably introduced in one of the cavities permitting the optoelectronic device to work as an intensity-modulated light-emitting diode or diode laser by applying an injection current. The device preferably contains at least three electric contacts to apply forward or reverse bias and may operate as a vertical cavity surface emitting light-emitter or modulator or as a tilted cavity light emitter or modulator. The problem of this device, however, is need in very strict growth tolerances, as the device operation is extremely sensitive to the spectral position of the cavity mode of the wavelength-tunable resonating cavity with respect to the VCSEL cavity mode. Assuming the growth rate non-uniformity for different materials used in the modulator and the VCSEL sections, there is unavoidable non-uniformity in device performance across the wafer. Another disadvantage is the fact that the output power is a non-monotonous function of the applied voltage. The device has low power in the absence of the applied voltage (the cavities are out of resonance), the power is high at a certain voltage (the cavities are in resonance), and the power is again low at even higher bias voltages (the cavities are out of resonance).

As the standard telecom and datacom devices operate only in the "on-off' mode, this non-monotonous characteristic is highly undesirable.

The surface emitting laser according to EP 0 618 651 A2 is provided with a resonator having a structure where a light absorption wavelength region is changed due to the Wannier-Stark effect or quantum-confinement Stark effect is formed in the non-doped Distributed Bragg Reflector mirror at the opposite side to a semiconductor substrate out of a pair of Distributed Bragg Reflector mirrors sandwiching the resonator.

US 6,865,214 discloses a wavelength tunable VCSEL. The wavelength tunable VCSEL includes a current constricting layer which is formed on a lower distributed Bragg reflector, upper and lower electrodes for laser oscillation, and additional electrodes which are formed on a predetermined region of an upper distributed Bragg reflector from which light is emitted so as to vary a width of an effective resonance region. Compared to other VCSEL, the wavelength tunable VCSEL according to US 6,865,214 can rapidly change a wavelength of emitted light and prevent the deterioration of gain characteristics of laser oscillation due to variations in the width of the effective resonance region according to variations in a temperature.

Thus, there is a need in the art for an all-epitaxial design for a robust ultrafast way to modulate the intensity of the emitting light from an optoelectronic device. Solutions for both direct and indirect modulation are highly needed.

## SUMMARY OF THE INVENTION

According to the present invention a semiconductor optoelectronic device with the features of independent claims 1 and 2 is provided.

A vertically integrated optoelectronic device is disclosed that allows high-speed data transfer by means of direct modulation of the intensity of the emitted light, indirect modulation of the intensity and/or wavelength of the emitted light, or any combination of such means. In one embodiment of the present invention, a device contains at least one wavelength-tunable multilayer interference reflector controlled by an applied voltage and at least one cavity. The multilayer interference reflector or its part operates as a modulator element such that the stopband edge wavelength of the wavelength-tunable multilayer interference reflector is preferably electrooptically tuned using the quantum confined Stark effect in the vicinity of the cavity mode (or a composite cavity mode), resulting in a modulated transmittance of the multilayer interference reflector. A light generating element containing an active region is preferably introduced in the cavity or in one of the cavities permitting the optoelectronic device to work as an intensity-modulated light-emitting diode or diode laser by applying an injection current. The device preferably contains at least three electric contacts to apply forward or reverse bias independently to the light generating element and to the modulator element and can operate as a vertical cavity surface emitting light-emitter or modulator or as an edge-emitting light emitter or modulator.

Another embodiment of the present invention includes a vertically integrated optoelectronic device with a multilayer interference reflector containing a tunable section which allows the device to operate as a wavelength-tunable laser or a wavelength-tunable resonant cavity photodetector in the case where the optical field profile in the active cavity or cavities is affected by the shift of the stopband wavelength.

## BRIEF DESCRIPTION OF THE DRAWINGS

Fig. 1(a)     shows a schematic diagram of a prior art edge-emitting device.

Fig. 1 (b)     shows a schematic diagram of a prior art vertical-cavity surface-emitting device.

Fig. 2     shows a schematic diagram of a device operating in the high-order mode, for example, tilted cavity laser device.

Fig. 3     shows a schematic diagram of the emission distribution in the prior art device of Fig. 1(b).

Fig. 4     shows schematically a semiconductor structure incorporating a plane of optical oscillators emitting at certain wavelength of light in vacuum or in an isotropic medium. The emission of such oscillators is isotropic.

Fig. 5(a)     shows a schematic diagram of the device of Fig. 1(b) in respect to the three groups of emission: vertical cavity emission, in-plane waveguiding emission and the tilted emission.

Fig. 5(b)      shows a schematic diagram of the mode intensity distribution in the device with a guiding cavity.

Fig. 5(c)      shows a schematic diagram of the mode intensity distribution in the device with an anti-guiding cavity.

Fig. 6         shows a schematic diagram of a prior art electronically intensity-modulated vertical cavity surface emitting laser including a wavelength-tunable cavity with a modulating element, and a cavity with light generating element.

Fig. 7(a)      shows schematically optical absorption spectra of the resonantly absorbing element, incorporated in the modulator cavity of the prior art device under zero bias and under reverse bias. The quantum confined Stark effect causes red shift of the absorption maximum and a broadening of the peak.

Fig. 7(b)      shows schematically refractive index modulation spectra of the resonantly absorbing element, incorporated in the modulator cavity of the prior art device under zero bias and under reverse bias. There is an enhancement of the refractive index at certain wavelength (dashed vertical line), which may be a lasing wavelength of the vertical-cavity surface-emitting laser section of the device.

Fig. 7(c)      shows a reflectivity dip of the modulator cavity under zero bias.

Fig. 7(d)      shows a reflectivity dip of the modulator cavity under reverse bias. Note that the transparency of the system laser-modulator is increased. Further increase in voltage will result, however, in reduced transparency at the same wavelength.

Fig. 8(a)      shows a schematic diagram of the device of Fig. 6.

Fig. 8(b)      shows a schematic diagram of the absolute value of the electric field strength profile of the laser optical mode of the device of Fig. 6 where the modulator is in the resonant state.

Fig. 8(c)      shows a schematic diagram of the absolute value of the electric field strength profile of the laser optical mode of the device of Fig. 6 where the modulator is in a non-resonant state.

Fig. 9         shows a schematic diagram of a vertically integrated optoelectronic device, namely, an intensity-modulated surface emitting laser, according to one embodiment of the present invention, including a light generating element and a tunable stopband distributed Bragg reflector, where a modulator is placed in the distributed Bragg reflector. The light emission can be realized from both the surface and the substrate side. The vertical alignment of the tunable stopband reflector and the laser cavity can be also reversed. Oxide-confined apertures can be used.

Fig. 10(a)     shows schematically optical absorption spectra of the resonantly absorbing element, incorporated in the modulator cavity of the device under zero bias and under reverse bias. The quantum confined Stark effects causes red shift of the absorption maximum and a broadening of the peak.

Fig. 10(b)     shows schematically refractive index modulation spectra of the resonantly absorbing element, incorporated in the modulator cavity of the device under zero bias and under reverse bias. There is an enhancement of the refractive index at certain wavelength (dashed vertical line), which may be a lasing wavelength of the vertical-cavity surface-emitting laser section of the device.

Fig. 10(c)     shows a reflectivity spectrum of the modulator cavity under zero bias.

Fig. 10(d)     shows a reflectivity spectrum of the modulator cavity under reverse bias. Note that the transparency of the system laser-modulator is decreased. Further increase in voltage will result, in further reduced transparency at the same wavelength.

Fig. 11        shows possible positioning of the lasing wavelength as compared to the modulated stopband edge of the multilayer interference reflector.

Fig. 12(a)   shows a schematic diagram of the device of Fig. 9.

Fig. 12(b)   shows a schematic diagram of the absolute value of the electric field strength profile of the laser optical mode of the device of Fig. 9 where the modulator is in the state ensuring low reflectivity of the stopband edge of the multilayer interference reflector.

Fig. 12(c)   shows a schematic diagram of the absolute value of the electric field strength profile of the laser optical mode of the device of Fig. 9 where the modulator is in the state ensuring high reflectivity of the stopband edge of the multilayer interference reflector.

Fig. 13   shows a schematic diagram of a vertically integrated optoelectronic device, namely, an intensity-modulated surface emitting laser, according to another embodiment of the present invention, including a light generating element and a tunable stopband distributed Bragg reflector, where a modulator is placed in the distributed Bragg reflector. Proton bombardment or ion implantation of the top modulator mesa can be used to ensure very low capacitance of the modulator section.

Fig. 14   shows a schematic diagram of a vertically integrated optoelectronic device, namely an intensity-modulated surface emitting laser, according to yet another embodiment of the present invention,

Fig. 15   shows a schematic diagram of a vertically integrated optoelectronic device, namely, an intensity-modulated tilted cavity surface emitting laser including a light generating element and a tunable stopband multilayer interference reflector element, where a modulator is placed in the multilayer interference reflector element.

Fig. 16   shows a schematic diagram of a cross-sectional view of an electrooptically modulated edge-emitting laser including a light generating element and a stopband edge-modulated multilayer interference reflector element. Modulated absorption causes light intensity modulation in the exit waveguide. The embodiment of Fig. 16 is not an embodiment of the present invention.

Fig. 17   shows a schematic diagram of a cross-sectional view of the device of Fig. 16 in the perpendicular cross section plane.

Fig. 18   shows schematically the principle of the wavelength tuning in the electrooptically Bragg-reflector stopband tunable vertical cavity surface emitting laser of the present invention. Fig. 18(a) shows schematically the device wherein the second Bragg reflector is switched to a non-transparent state.

Fig. 18(b)   shows schematically the electric field strength in the resonant optical mode of the device, wherein the second DBR is switched to a non-transparent state.

Fig. 18(c)   shows schematically the device wherein the second Bragg reflector is switched to a transparent state.

Fig. 18(d)   shows schematically the electric field strength in the resonant optical mode of the device, wherein the second DBR is switched to a transparent state.

Fig. 19   shows a schematic diagram of a vertically integrated optoelectronic device, namely an electrooptically wavelength-modulated surface emitting laser according to one of the embodiments of the present invention.

Fig. 20   shows a schematic diagram of a vertically integrated optoelectronic device, namely, an electrooptically wavelength-modulated resonant cavity photodetector not being an embodiment of the present invention.

Fig. 21(a)   shows a schematic diagram of a vertically integrated optoelectronic device, namely, an electrooptically modulated leaky edge-emitting laser according to yet another embodiment, wherein the multilayer interference reflector is switched to a transparent state. The embodiment of Fig. 21 (a) is not an embodiment according to the present invention.

Fig. 21(b)   shows a schematic diagram of a vertically integrated optoelectronic device, namely, an electrooptically modulated leaky edge-emitting laser according to yet another embodiment, wherein the multilayer interference reflector is switched to a non-transparent state. Fig. 21(b) does not show an embodiment of the present invention.

Fig. 22(a)     shows schematically an optical oscillator emitting light with a certain photon energy corresponding to a certain wavelength of light in the vacuum $\lambda_0$, wherein the optical oscillator is inserted into a medium with modulated refractive index, such that the emission in some directions is allowed, whereas the emission in some other direction is forbidden.

Fig. 22(b)     shows schematically a periodic layered structure, the prior art reflectivity spectra of which are given in Figs. 22(c) through 22(f).

Fig. 22(c)     through 22(f) shows prior art optical reflectivity spectra of a periodic layered structure as a function of angle of incidence of the light from the reference medium. Fig. 22(c) shows the optical reflectance spectrum of the periodic layered structure of Fig. 22(b) at the angle of incidence of the light $\vartheta=65°$. The selected wavelength of light $\lambda_0$ appears to be in the center of the reflectivity stopband at this angle.

Fig. 22(d)     shows the prior art optical reflectivity spectrum of the periodic layered structure of Fig. 22(b) at the angle of incidence of the light $\vartheta=55°$.

Fig. 22(e)     shows the prior art optical reflectivity spectrum of the periodic layered structure of Fig. 22(b) at the angle of incidence of the light $\vartheta=40°$.

Fig. 22(f)     shows the prior art optical reflectivity spectrum of the periodic layered structure of Fig. 22(b) at the normal incidence of the light ($\vartheta=0°$).

Fig. 23     shows schematically optical field distribution in one of the tilted modes of Fig. 5(b) having the strongest intensity in the active region. One can see, in particular, that this mode has an intensity maximum in the active region. For the tilted modes having a low intensity in the active zone the confinement factor is small and the related emission is weak. Thus, it is only a certain range of angles causing the most of the parasitic radiative losses.

Fig. 24     shows a schematic diagram of a vertically integrated optoelectronic device, according to a further embodiment. The DBRs in the device have two periodicities. The first periodicity provides VCSEL DBRs to support vertical lasing and the second periodicity provides a stopband for emission of light in the relevant angle range. Fig. 24 does not show an embodiment according to the represent invention.

Fig. 25(a)     shows schematically refractive index profile a single-periodicity DBR in a standard prior-art VCSEL device.

Fig.     25(b) shows schematically refractive index profile a double-periodicity DBR in a device, wherein the second periodicity is realized by increasing the refractive index of the low-refractive index component. The double periodicity illustrated in Fig. 25(b) provides a coarse-scale period, comprising eight fine-scale layer pairs. Four layer pairs out of eight form a so called periodicity 1, and the rest four layer pairs out of eight form a so called periodicity 2.

Fig. 25(c)     shows schematically refractive index profile a double-periodicity DBR in a device, wherein the second periodicity is realized by decreasing the refractive index of the high-refractive index component. The double periodicity illustrated in Fig. 25(c) provides a coarse-scale period, comprising eight fine-scale layer pairs. Four layer pairs out of eight form a so called periodicity 1, and the rest four layer pairs out of eight form a so called periodicity 2.

Fig. 25(d)     shows schematically refractive index profile a double-periodicity DBR in a device, wherein the second periodicity is realized by changing the relative thickness in the DBR keeping the same fine-scale periodicity. The double periodicity illustrated in Fig. 25(c) provides a coarse-scale period, comprising eight fine-scale layer pairs. Four layer pairs out of eight form a so called periodicity 1, and the rest four layer pairs out of eight form a so called periodicity 2.

Fig. 26     shows a schematic diagram of a vertically integrated optoelectronic device, wherein an additional part of the bottom distributed Bragg reflector (DBR) is added to the device of the embodiment of Fig. 24, wherein the additional part of the DBR has a different refractive index profile compared with the DBR of the embodiment of Fig. 24. Fig. 26 does not show an embodiment according to the present invention.

Fig. 27    shows a schematic diagram of a device, wherein the device is optimized for tilted emission of the allowed component of light. Fig. 27 does not show an embodiment according to the present invention.

Fig. 28    shows a schematic diagram of a vertically integrated optoelectronic device, wherein a single periodicity of the DBRs prohibits parasitic radiative losses at large tilted angles. Fig. 28 does not show an embodiment according to the present invention.

Fig. 29    shows a schematic diagram of a vertically integrated optoelectronic device, wherein the double periodicity of the multilayer interference reflector is optimized for in-plane light propagation and prohibits the emission in vertical and tilted directions. Fig. 29 does not show an embodiment according to the present invention.

Fig. 30    shows a schematic diagram of a vertically integrated optoelectronic device, wherein both DBRs have two periodicities, and one of the layers in each pair of layers in one of the periodicities is formed from GaAlAs or AlAs and is further oxidized to form a partially oxidized layer of GaAlO or AlO. Fig. 30 does not show an embodiment according to the present invention.

Fig. 31    shows a schematic diagram of a vertically integrated optoelectronic device, wherein a device of the embodiment of Fig. 30 is processed further such, that partially oxidized layers of GaAlO or AlO are etched thus forming air gaps. Fig. 31 does not show an embodiment according to the present invention.

Fig. 32    shows a schematic diagram of a vertically integrated optoelectronic device, wherein intracavity contacts are used, both DBRs have two periodicities, and one of the layers in each pair of layers in one of the periodicities is formed from GaAlAs or AlAs and is further oxidized to form a completely oxidized layer of GaAlO or AlO. Fig. 32 does not show an embodiment according to the present invention.

Fig. 33    shows a schematic diagram of a vertically integrated optoelectronic device, wherein both DBRs have two periodicities, and one of the layers in each pair of layers in one of the periodicities is formed from GaAlAs or AlAs and is further oxidized to form a partially oxidized layer of GaAlO or AlO, the device is further processed such that the oxide layers are etched out forming air gaps, and wherein the processing is asymmetric, such that air gaps are formed also in the central part of the device. Fig. 33 does not show an embodiment according to the present invention.

Fig. 34    shows a schematic diagram of a vertically integrated optoelectronic device, namely an electrooptically Bragg-reflector stopband tunable vertical cavity surface emitting laser. The device is set to modulate the wavelength of the emitted light. Double periodicity is introduced in one of the Bragg reflectors, to suppress parasitic modes. Thus, the device of Fig. 34 allows independent modulation of both the wavelength and intensity of the emitted light at a high speed.

## DETAILED DESCRIPTION OF THE INVENTION

The present invention provides an ultrafast way to modulate the intensity of light emitted by an optoelectronic device. A vertically integrated optoelectronic device is disclosed addressing and solving the problem of the ultrafast modulation of the intensity of light.

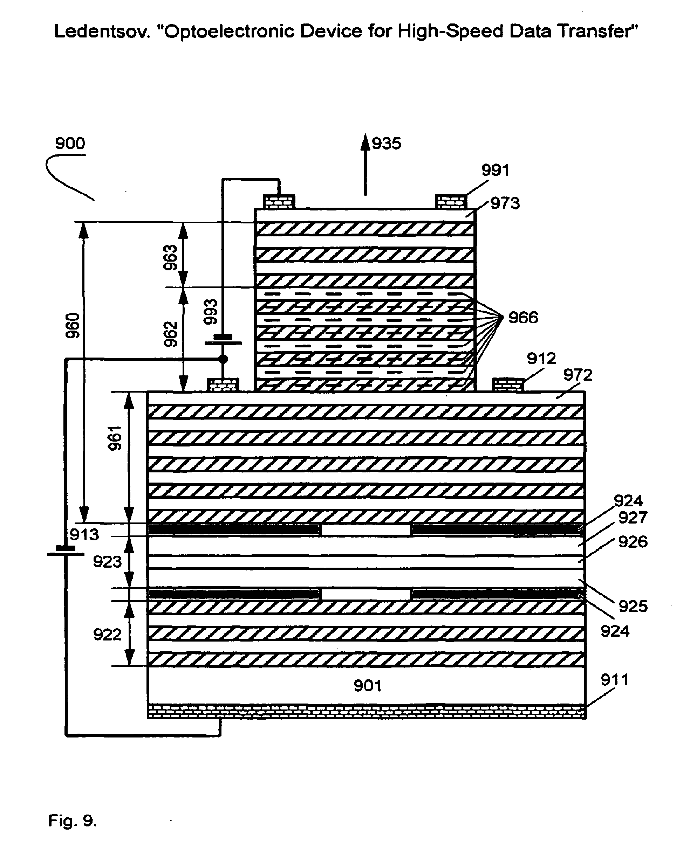

Figure 9 shows a schematic diagram of a vertically integrated optoelectronic device, namely, an electrooptically-modulated vertical cavity surface emitting laser (900) according to a preferred embodiment of the present invention. The modulator element is integrated with the multilayer interference reflector element, for example, distributed Bragg reflector (DBR). By varying a voltage applied to a modulator, its refractive index changes. The stopband of the DBR then shifts towards the wavelength of the generated laser light, and prevents it's penetration through the top DBR structure. Thus, the output intensity of the device is modulated. Thus, the device operates as an electronically wavelength tunable DBR stopband edge vertical cavity surface emitting laser providing output laser light modulated in intensity.

The device (900) of the embodiment shown in Fig. 9 is grown epitaxially preferably on a p-doped substrate (901) and comprises a first, or bottom DBR (922), which is preferably p-doped, the light generating element (923), and a second, or top DBR (960). The top DBR (960) preferably comprises a first part (961), which is preferably n-doped, a second part (962), which is preferably undoped, and a third part (963), which is preferably p-doped. The light generating element (923) preferably includes a weakly p-doped or an undoped layer (925), an active region (926), and a weakly n-doped or an undoped layer (927).

The active region (926) is formed of any insertion or combinations of insertions, including a double heterostructure, a quantum well, an array of quantum wires, and arrays of quantum dots, or any combination thereof. The active region generates light, when a forward bias (913) is applied via the p-contact (911) and the n-contact (912). In this embodiment, a current spreading n-layer is formed (972) between the first part (961) of the top DBR (960) and the second part (962) of the top DBR (960). Current apertures (924) are introduced between the bottom DBR (922) and the light generating element (923), and between the light generating element (923) and the top DBR (960).

The second part (962) of the top DBR (960) operates as a modulator element. A reverse bias (993) is applied to the undoped part (962) of the top DBR (960) via the n-contact (912) and the p-contact (991). The modulator element preferably includes a single or multiple quantum insertions (966), which can be a single or multiple quantum wells, a single or multiple layers of quantum wires, a single or multiple layers of quantum dots, or any combination thereof.

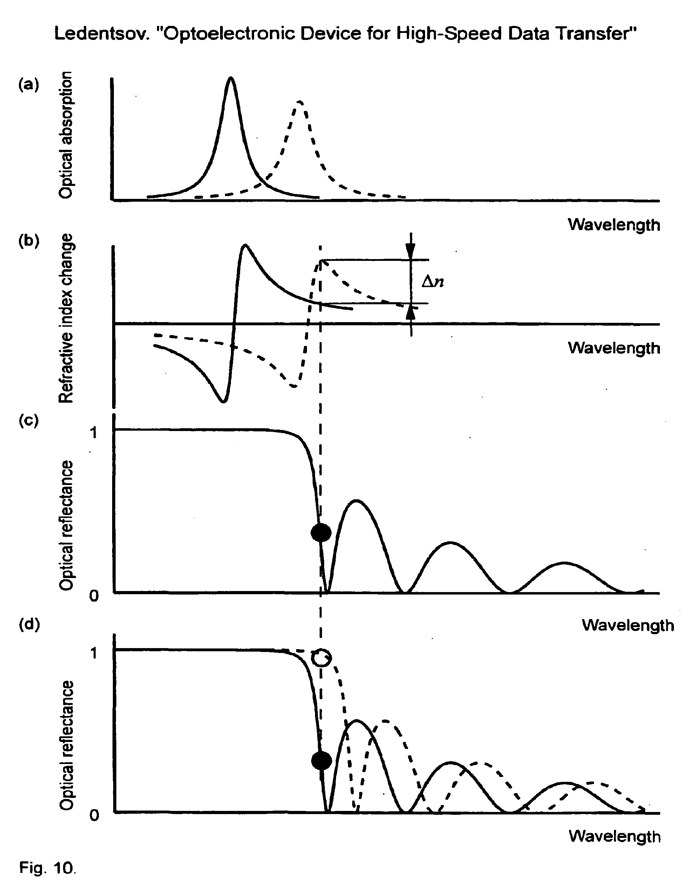

Figure 10 schematically explains the operation of the device. Under a reverse bias, an electric field applied to the quantum insertions in the modulator region causes a quantum confined Stark effect. The latter results in a shift of the spectral position of the optical absorption peak. Due to Kramers-Kronig relationship between the real and the imaginary parts of the dielectric functions, a change in the absorption spectrum is accompanied by a corresponding variation of the refractive index. The change in the refractive index of the modulator leads to a shift in the stopband edge wavelength of the modulator element. Thus, by applying a different value of the reverse bias, it is possible to shift the stopband edge wavelength of the filter element. This allows the modulator element to turn the device into the closed state with minimum light intensity coming out of the device. The DBR stopband edge may be alternatively placed being red-shifted from the lasing wavelength.

The functionality of the devices of the present invention is based on electrooptical effect, namely on a change in the refractive index when an electric field is applied. If an electric field is applied perpendicularly to the layers, the conduction and the valence bands of the semiconductor device tilt due to the potential of the external field resulting in the shifting of the energy levels. This results in a smaller absorption energy, and the absorption edge shifts to longer wavelengths. The effect in bulk materials is known as the Franz-Keldysh effect (I. Galbraith, B. Ryvkin "Empirical determination of the electroabsorption coefficient in semiconductors", J. Appl. Phys. 74, 4145 (1993)). A change in the absorption coefficient $\Delta\alpha$ (electroabsorption) results also in a refractive index change $\Delta n$ (electrorefraction). The latter can be calculated by Kramers-Kronig transform, (see, e.g., D.S. Chelma et al. "Room Temperature Excitonic Nonlinear Absorption and Refraction in GaAs/AlGaAs Multiple Quantum Well Structures", IEEE Journal of Quantum Electronics, Vol. QE-20 (3), pp. 265-275 (1984)),

$$\Delta n(\omega) = \frac{c}{\pi} P \int_0^\infty \frac{\Delta\alpha(\omega')}{\omega'^2 - \omega^2} d\omega'. \tag{2}$$

where the symbol P indicates that the principal value of the integral has to be evaluated, and c is the velocity of light.

The phenomenon in quantum confined structures like quantum wells, quantum wires or quantum dots is referred to as the Quantum Confined Stark Effect. In realistic electric fields, ranging from zero to a few hundred kV/cm, the electrorefraction is described as a sum of a linear eletrooptical effect (Pockel's effect) and a quadratic electrooptical effect (Kerr effect), (see, e.g. J.E. Zucker, T.L. Hendrickson, and C.A. Burrus, "Electro-optic phase modulation in GaAs/AlGaAs quantum well waveguides", Applied Physics Letters, Vol. 52 (12), pp. 945-947 (1988)).

$$\Delta n = \frac{1}{2} n_0^3 \left( rF + sF^2 \right), \tag{3}$$

where $F$ is the electric field strength, $n_0$ is the refractive index in the zero electric field, and $r$ and $s$ are the linear and quadratic electrooptical coefficients.

In GaAs/GaAlAs quantum well structures, the quadratic electrooptical effect dominates at electric fields of about 50 kV/cm (see J.S. Weiner et al., "Quadratic electro-optic effect due to the quantum-confined Stark effect in quantum wells", Applied Physics Letters, Vol. 50 (13), pp. 842-844 (1987) and J.E. Zucker et al. "Quaternary quantum wells for electro-optic intensity and phase modulation at 1.3 and 1.55 $\mu$m", Applied Physics Letters, Vol. 54 (1), pp. 10-12 (1989)). Furthermore, the quadratic electrooptical coefficient s in GaInAs/InP, GaInAsP/InP, and GaAs/GaAlAs quantum well structures is inversely proportional to the detuning $\Delta\omega$ between the exciton energy in the zero electric field and the photon energy below the bandgap, at which the refractive index is considered,

$$\Delta n = \frac{\eta F^2}{\Delta \omega}. \tag{4}$$

Here $\eta$ is the so called figure of merit, which was estimated to be of the order of $3 \times 10^{-5}$ $meV\ cm^2\ kV^{-2}$. The behavior (Eq. (4)) had initially been experimentally studied for quantum wells having a width between 6 and 10 nm, and detunings up to 40 meV. The electrooptical effect decreases at larger detuning (from 40 to 140 meV) much faster than given by Eq. (4) (see M.P. Earnshow and D.W.E. Allshop, "Electrooptic Effects in GaAs-AlGaAs Narrow Coupled Quantum Wells", IEEE Journal of Quantum Electronics, Vol. 37 (7), pp. 897-904; ibid. Vol. 37 (8), p. 1103 (2001)).

Although the exciton peak absorption decreases significantly upon applied electric field (see, e.g., L. Chen, K.C. Rajkumar, and A. Madhukar "Optical Absorption and Modulation Behavior of Strained InxGal-xAs/GaAs (100) (x ≤ 0.25) multiple quantum well structure grown via molecular beam epitaxy", Applied Physics Letters, Vol. 57 (23), pp. 2478-2480 (1990)), the exciton line width increases correspondingly. The integral excition absorption is proportional to the oscillator strength, which can also be roughly estimated to be proportional to the product of the peak absorption by the exciton line width, may either decrease much slower or even remain unchanged.

The exciton oscillator strength in a rather narrow quantum well remains unaffected by an applied electric field if the quantum well width is smaller than one half of the exciton Bohr radius (see Feng et al. "Exciton energies as a function of electric field: Confined quantum Stark effect", Physical Review B, Vol. 48 (3), pp. 1963-1966 (1993)). For InGaAs quantum wells in GaAs, this means quantum wells preferably 7 nm or thinner. The unaffected oscillator strength implies unaffected integral excition absorption. Additionally, there is evidence of an increased electrooptical effect in narrow coupled quantum wells.

While selecting particular quantum wells for the modulator for the present invention, as well as particular values of the detuning and electric field, it is important to take into account electrooptical effects and their theroretical modeling, which are published in the references cited above.

In a different embodiment of the present invention, the modulator region operates under a forward bias. This causes the exciton bleaching effect that changes the optical absorption peak and thus affects the refractive index of the modulator.

In yet another embodiment of the present invention a resonant cavity light-emitting diode comprises an electrooptically-modulated Bragg reflector. Applying bias to a Bragg reflector or its part, it is possible to modulate intensity of light coming out of the light-emitting diode.

In a further embodiment of the present invention, a superluminescent light-emitting diode comprises an electrooptically-modulated Bragg reflector. Applying bias to a Bragg reflector or its part, it is possible to modulate intensity of light coming out of the superluminescent light-emitting diode.

Figure 10 illustrates the principles of the operation of the electronically wavelength tunable vertical cavity surface emitting laser of Fig. 9. Figure 10(a) shows schematically the position of the optical absorption peak being shifted with applied voltage, due to the Stark effect. Due to Kramers-Kronig relationship between the real and imaginary parts of the dielectric function of the medium, the shift of the absorption peak results in a modulation of the refractive index of the modulator, as it is shown in Fig. 7(b). The modulation of the refractive index of the modulator leads to a shift of the stopband edge wavelength of the modulator-DBR section from position depicted in Fig. 10(c) to the position in Fig. 10 (d), dashed line. This shift results in suppression of the modulator transparency, and, thus, in a lower output power of the device.

Different embodiments resulting in a shift of the DBR stopband edge are possible. Let the DBR consist of alternating layers having, at zero bias, refractive indices $n_1$ and $n_2$. Then, in one of the embodiments, quantum insertions are selected such that applying of the reverse bias results in an increase of the refractive indices of both layers.

$$\Delta n_1 > 0, \text{ and } \Delta n_2 > 0, \tag{5}$$

which further leads to a shift of the longwavelength stopband egde towards longer wavelengths. In another embodiment, quantum insertions are selected such that, upon an applied reverse bias, indices of the two layers change in opposite directions, and the optical contrast increases,

$$\Delta |n_2 - n_1| > 0, \qquad\qquad (6)$$

which also further leads to a shift of the longwavelength stopband egde towards longer wavelength.

In yet another embodiment of the present invention, light output through the substrate is used. If the top DBR in the non-transparent state has the transparency comparable or lower than the transparency of the bottom DBR, the light output power through the bottom DBR and the substrate will be modulated. Thus, the device may operate in both directions, but the "on" and "off" states will be reversed. Namely, switching the top DBR to the "off" regime may lead to the enhancement of the light output through the bottom DBR, and vice versa.

In one another embodiment of the present invention, the transparency of the bottom DBR is modulated. Light output power through the bottom DBR and the substrate is modulated accordingly.

In yet another embodiment of the present invention, the transparency of the bottom DBR is modulated, and light output through the top DBR is modulated in the reverse manner.

In one another embodiment, the modulator region operates under a forward bias. Applying a forward bias results in an exciton bleaching effect, which further leads to a change in refractive index of the modulator region and the shift of the Bragg reflector stopband is of the opposite side.

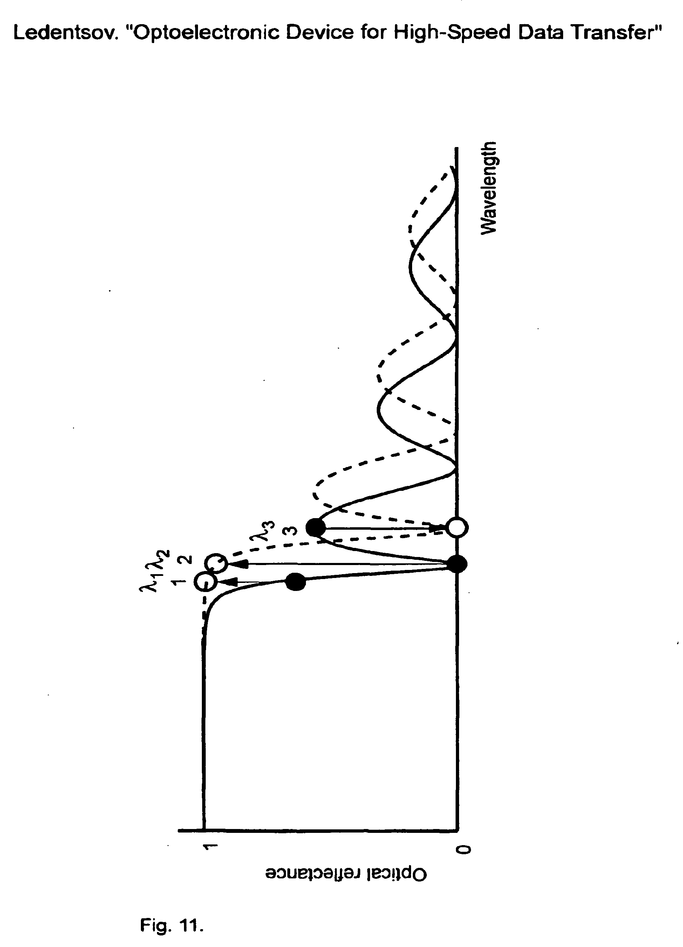

Figure 11 illustrates the fact that the transparency of the DBR may be modulated in both directions. Applying the reverse bias to the modulator element results in a shift of the spectral features to longer wavelengths. This is illustrated in Fig. 11, where the optical reflectance of a DBR shown as a solid line is shifted to a new spectral position where it is shown by a dashed line. If the laser wavelength is chosen as $\lambda_1$ or $\lambda_2$, then the shift of the DBR optical reflectance spectrum leads to an increase in DBR reflectivity, the DBR becoming less transparent. If the laser wavelength is chosen as $\lambda_3$, the shift of the DBR optical reflectance spectrum leads to a decrease in DBR reflectivity, the DBR becoming more transparent.

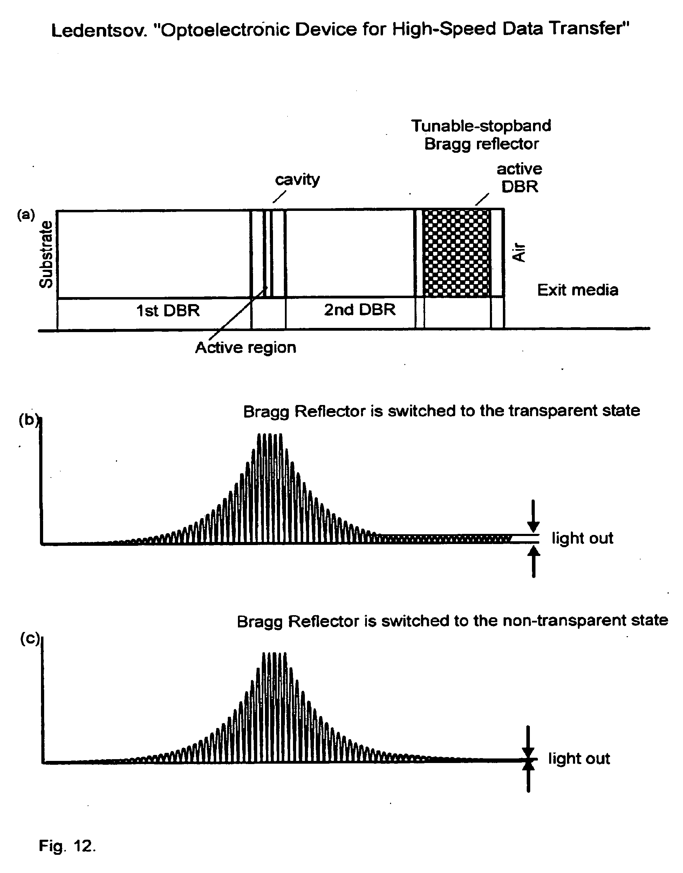

Figure 12(a) shows schematic diagram of the device of Fig. 9 in a simple form, showing only some of the elements. The elements shown include the substrate, the first distributed Bragg reflector, the first cavity (which includes the active region), the second distributed Bragg reflector and the third "modulator" distributed Bragg reflector (which includes the modulator elements) and the contact region or a fourth distributed Bragg reflector.

Figure 12(b) shows the spatial profile of the resonant optical mode of the device where the modulator is switched to the state, where the DBR reflectivity stopband does not overlap with the lasing wavelength. Figure 12(b) plots the absolute value of the electric field strength in the optical mode. As there is no attenuation of the optical wave in the modulator DBR the field intensity does not change significantly in this region. Consequently, the light output power proportional to the field intensity in the air is high.

Figure 12(c) shows the spatial profile of the resonant optical mode of the device where the modulator is switched to a reflecting, or non-transparent state. Figure 12(c) plots the absolute value of the electric field strength in the optical mode. In the reflecting DBR state, the laser generates the laser light at any wavelength that does not correspond to the transparency regime of the DBR. Therefore, the optical mode of the laser will decay in the DBR. Consequently, the light output power proportional to the field intensity in the air is low.

By alternating a bias voltage applied to the modulator, one switches the device between the transparent state and non-transparent state. As the stopband edge can be made arbitrarily abrupt, a significant modulation depth can be realized. An additional advantage is the fact that for high-order transverse optical modes, having a shorter wavelength than the fundamental optical mode, the stopband edge wavelength is also shifted to shorter wavelengths enabling robust operation also for multimode devices. The output light power alternates between a high intensity and a low intensity accordingly.

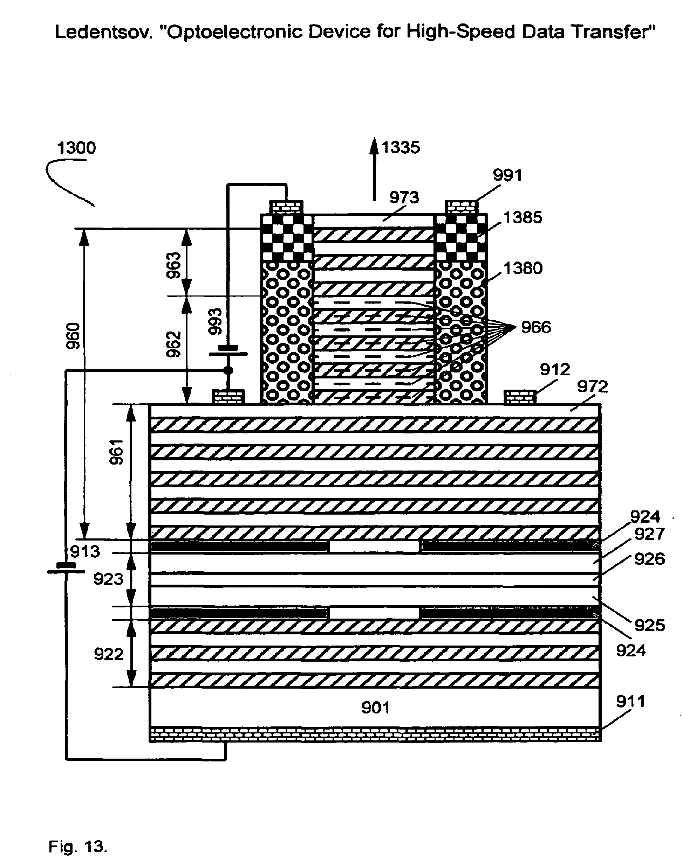

In order to provide high-frequency operation of the device, certain measures are preferably undertaken to reduce parasitic capacitance of the modulator region. Figure 13 shows a schematic diagram of an electrooptically-modulated vertical cavity surface emitting laser (1300) according to another embodiment of the present invention. The region underneath the top p-contact (991) is preferably subject to proton bombardment, which results in the formation of a region (1380) with a high concentration of defects and low conductivity. Thus, the region (1380) formed of initially n-doped or p-doped regions, will behave as a region of intrinsic, i.e. semi-insulating semiconductor. In order to provide a possibility to apply the bias (993) to the quantum insertions (966) within the modulator element, diffusion of Zn is preferably performed to the region (1385) underneath the top p-contact (991). Due to the diffusion of Zn, a part of semi-insulating region transforms in a p-doped highly conducting region, allowing to apply bias from the p-contact (991) to the quantum insertions (966). The modulated laser light (1335) comes out through the top DBR (960).

In one another embodiment of the present invention, the top DBR (960) does not comprise a third part (963).

In yet another embodiment of the present invention, the top DBR (960) does not comprise a first part (961).

And in one another embodiment of the present invention, the bias (993) is applied to the entire top DBR (960).

The modulator element (962) of Fig. 9 and Fig. 13 contains an n-i-p structure. In another embodiment of the present invention, the modulator element contains an n-i-n structure. In yet another embodiment of the present invention, the modulator element contains a p-i-p structure. Here "i" denotes "intrinsic" or weakly doped region.

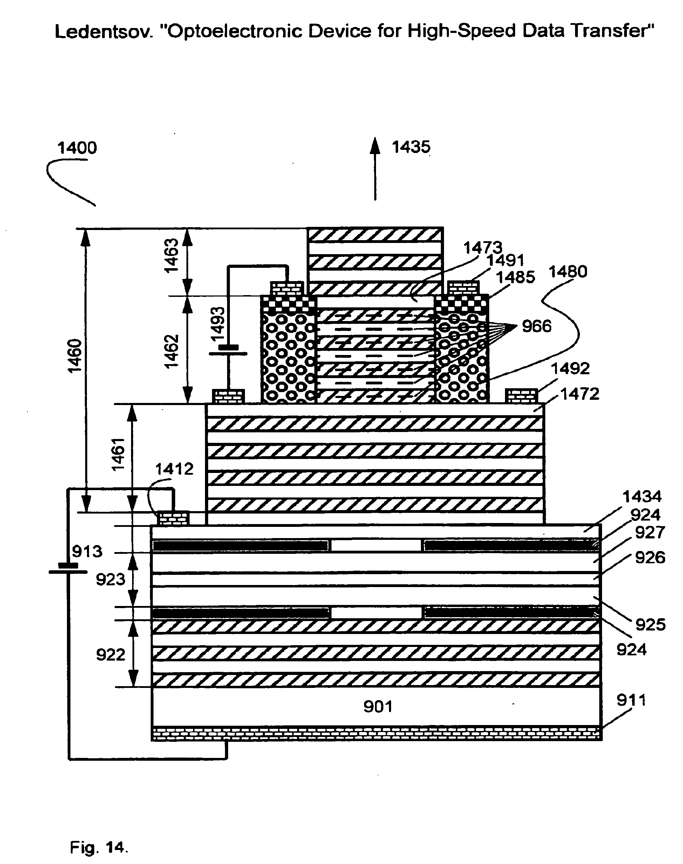

Figure 14 shows a schematic diagram of an electrooptically-modulated vertical cavity surface emitting laser (1400) according to yet another embodiment of the present invention. The device (1400) is a four-contact device, which allows to fabricated parts of the top DBR undoped thus reducing the optical losses due to the free carrier absorption of light. The device (1400) is grown epitaxially on a p-doped substrate (901) and comprises a bottom DBR (922), which is preferably p-doped, a light generating element (923), and a top DBR (1460). The top DBR (1460) preferably comprises a first part (1461), which is preferably undoped or weakly doped, a second part (1462), which is preferably undoped, and a third part (1463), which is preferably undoped or weakly doped.

The forward bias (913) is applied to the active region (926) in the light generating element (923) via the first p-contact (911), which is the bottom contact, and a first n-contact (1412), which is an intracavity contact. The first current spreading layer (1434), which is an n-current spreading layer is placed between the current aperture (924) and the first part (1461) of the top DBR (1460). The first current spreading layer (1434) is preferably heavily doped with an n-impurity. The first n-contact (1412) is mounted on the first current spreading layer (1434).

The second part (1462) of the top DBR (1460) is the modulator element. The reverse bias (1493) is applied to the quantum insertions (966) via the second n-contact (1492), which is fabricated as an intracavity contact, and the second p-contact (1491), which is also fabricated as an intracavity contact. The second current spreading layer (1472) which is the second n-current spreading layer, is placed between the first part (1461) of the top DBR (1460) and the second part (1462) of the top DBR (1460). The second current spreading layer (1472) is preferably heavily doped with an n-impurity. The second n-contact (1492) is mounted on the second n-current spreading layer (1472). The third current spreading layer (1473) which is a p-current spreading layer is placed between the second part (1462) of the top DBR (1460) and the third part (1463) of the top DBR (1460). The third current spreading layer (1473) is preferably heavily doped with a p-impurity. The second p-contact (1491) is mounted on the third current spreading layer (1473).

In order to provide high-frequency operation of the device (1400), certain measures are preferably undertaken to reduce parasitic capacitance of the modulator region. The region underneath the second p-contact (1491) is preferably subject to proton bombardment, which results in the formation of a region (1480) with a high concentration of defects and low conductivity. Thus, the region (1480) formed of initially n-doped or p-doped regions, will behave as a region of intrinsic, i.e. semi-insulating semiconductor. In order to provide a possibility to apply the bias (1493) to the quantum insertions (966) within the modulator element, diffusion of Zn is preferably performed to the region (1485) underneath the p-contact (1491). Due to the diffusion of Zn, a part of semi-insulating region transforms in a p-doped highly conducting region, allowing to apply bias from the p-contact (1491) to the quantum insertions (966).

Modulated laser light (1435) comes out through the top DBR (1460).

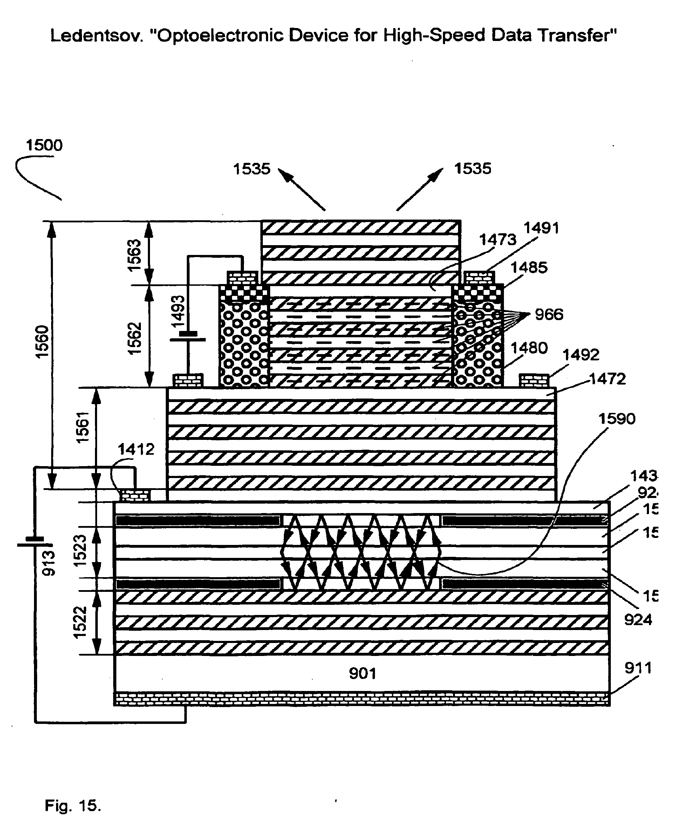

In a similar way, a tunable tilted cavity laser can be constructed. Figure 15 shows a schematic diagram of an electrooptically modulated tilted cavity surface emitting laser (1500) according to a **further** embodiment of the present invention. Electooptically tunable tilted cavity surface emitting laser (1500) is grown epitaxially on a substrate (901) which is preferably p-doped. The device comprises a first multilayer interference reflector, MIR, (1522), which is preferably p-doped, the light generating element (1523), and a second, or top MIR (1560). The top MIR (1560) preferably comprises a first part (1561), which is preferably undoped or weakly n-doped, a second part (1562), which is preferably undoped, and a third part (1563), which is preferably undoped or weakly p-doped. The light generating element (1523) preferably includes a weakly p-doped or an undoped layer (1525), an active region (1526), a weakly n-doped or an undoped layer (1527).

The active region (1526) is formed of any insertion or combinations of insertions, including a double heterostructure, a quantum well, an array of quantum wires, and arrays of quantum dots, or any combination thereof. The active region generates light, when a forward bias (913) is applied via the first p-contact (911) and the first n-contact (1412). In this embodiment, a current spreading n-layer is formed (1434) between the light generating element (1523) and the top MIR (1560). The second part (1562) of the top MIR operates as a modulator element. A reverse bias (1493) is applied to the second part (1562) of the top MIR via the second n-contact (1492) and the second p-contact (1491). The modulator element preferably includes a single or multiple quantum insertions (966), which can be a single or multiple quantum wells, a single or multiple layers of quantum wires, a single or multiple layers of quantum dots, or any combination thereof.

The light generating element (1523) forms a tilted cavity. The tilted cavity, the first MIR (1522), and the second MIR (1560) are selected such, that among various optical modes, a mode having the minimum leaky losses to the substrate and the contacts is a tilted optical mode (1590), in which light within the cavity propagates in a direction tilted with respect to both the p-n junction plane and to the direction normal to the p-n junction plane. Light of the tilted optical mode (1590) propagates through the second MIR (1560), and comes out of the device as tilted light (1535).

In one another embodiment of the present invention, light comes out of the electrooptically tunable tilted cavity surface emitting laser as vertically propagating light.

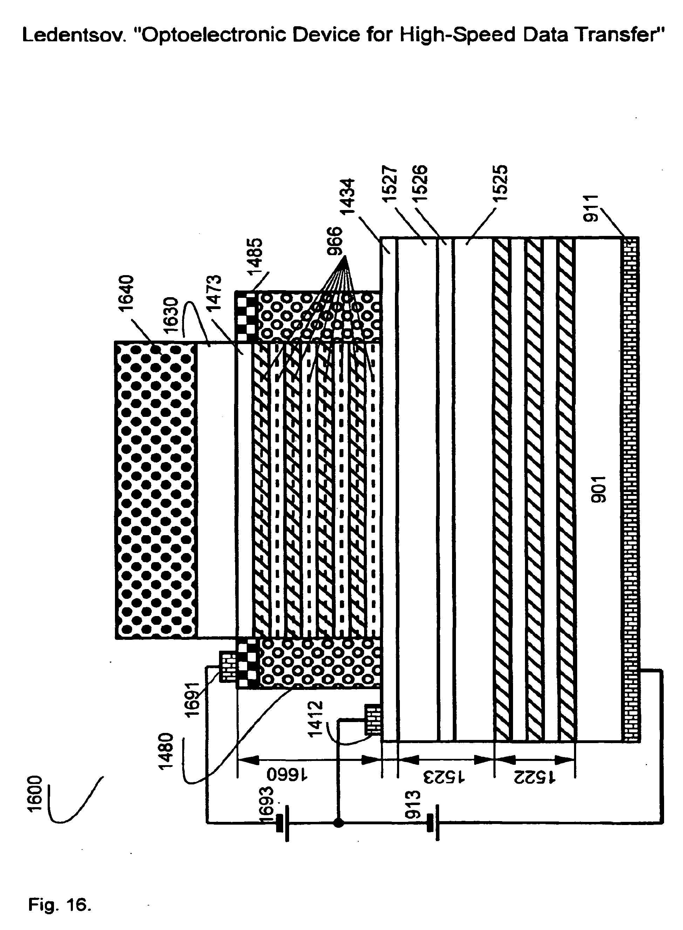

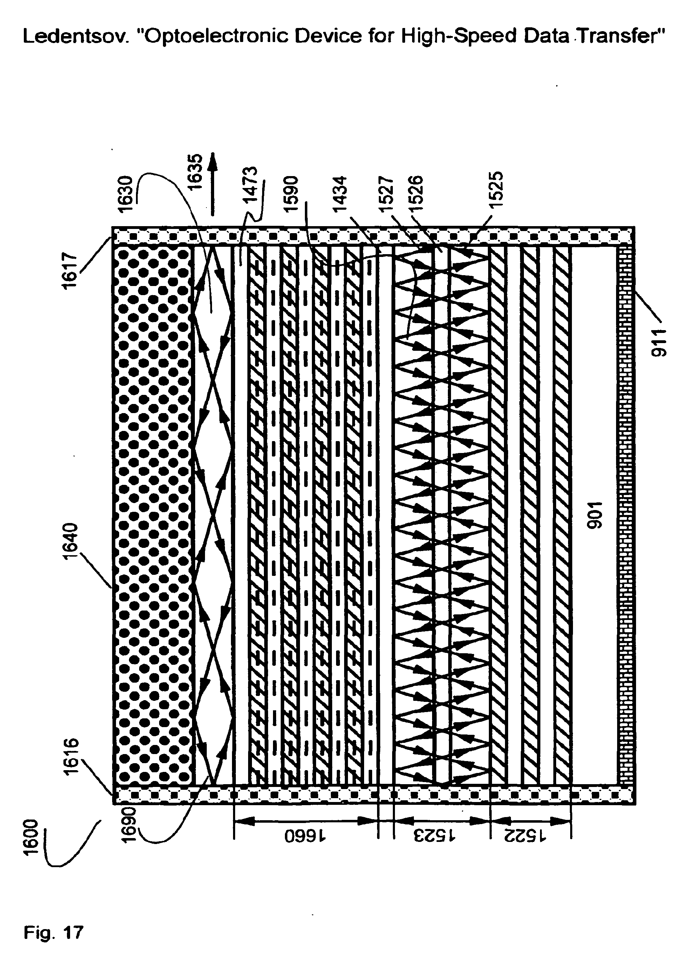

Figures 16 and 17 show a schematic diagram of an electronically intensity-modulated edge-emitting laser (1600) in two mutually perpendicular cross-sectional planes. Figure 16 shows a cross section in the vertical transverse plane, which is perpendicular to the direction of the propagation of laser light in the edge emitter. Figure 17 shows a cross section in the vertical longitudinal plane, parallel to the direction of propagation of the laser light in the edge emitter. An active cavity (1523), a first, bottom MIR (1522), and a second, top MIR (1660) are selected such that only one tilted optical mode (1590) has a high optical confinement factor in the active region (1526) and low loss. The active cavity (1523) is coupled to the exit waveguide (1630) via the top MIR (1660). The exit waveguide (1630) is bounded by the second MIR (1660) and the third reflector (1640) which is preferably an evanescent reflector. Due to different refractive indices of the active cavity (1523) and exit waveguide (1630), the single combined optical mode has different effective mode angles in the active cavity and in the exit waveguide. This is illustrated schematically as different tilt directions of the optical mode schematically by the closed line (1690) in the exit waveguide (1630) and of the same optical mode shown schematically by the closed line (1590) in the active cavity (1523). Thus, the light can exit the waveguide (1630) avoiding the effect of the total internal reflection on the side facets of the laser. Applying the reverse bias (1693) to the second MIR (1660) via the second p-contact (1691) and the n-contact (1412) results in the applying electric field to the quantum insertions (966). This leads to a change of the refractive indices of the insertions and, thus, may enhance or reduce penetration of the laser light to the exit waveguide (1630) and, thus, enhance or reduce the intensity of the emitted laser light (1635). A highly reflecting coat (1616) may be mounted on a rear facet, and an antireflecting coat (1617) may be mounted on a front facet such that laser light exits the exit waveguide only through the front facet.

In another embodiment a distributed feedback laser is fabricated, e.g. by introducing a grating in the exit waveguide (1630), in order to provide wavelength-stabilized operation of the device.

Electronically intensity-modulated light emitting diode can be realized in a similar approach.

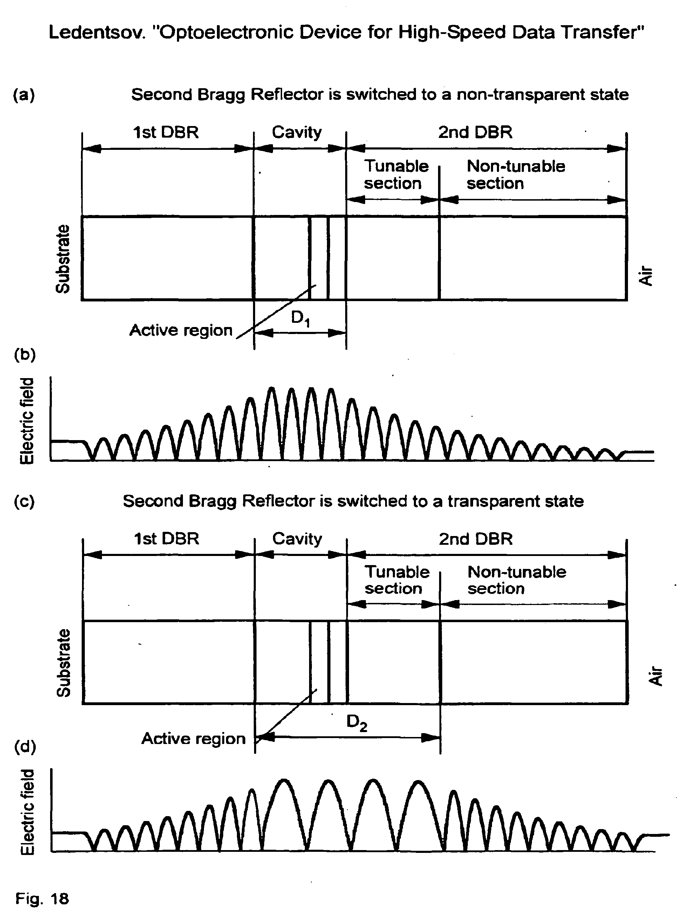

Figure 18 illustrates schematically a possibility to fabricate a wavelength-tunable laser based on an electrooptically modulated distributed Bragg reflector. Figure 18(a) shows schematically main elements of a laser, namely, a first DBR, a cavity with the active region, and a second DBR consisting of a tunable section and a non-tunable section. If the second DBR is switched to a non-transparent state, the wavelength of the emitted laser light is determined by the thickness of the cavity $D_1$. Figure 18(b) illustrates the spatial profile of the resonant optical mode, namely the absolute value of the electric field strength.

Figure 18(c) shows schematically the same device when the second DBR is switched to a transparent state. Then the tunable section of the DBR is transparent and may be qualitatively considered as a part of the cavity. Thus, the device contains an effective cavity with a thickness $D_2 > D_1$, and wavelength of the laser light will be determined by a modified effective thickness of the cavity. Figure 18(d) shows schematically the spatial profile of the resonant optical mode, namely the absolute value of the electric field strength.

When the device modulates the wavelength of the emitted laser light, it is preferred to separate the modulation of the wavelength and the modulation of the intensity, and to avoid the latter. Therefore, for the device of the embodiment schematically illustrated in Fig. 18, it is preferred to choose the first DBR weaker than the second DBR in the transparent state such that the main output of light will occur through the first DBR and the substrate. As the first DBR is not changed when the transparency of the second DBR is modulated, the intensity of the emitted laser light will not be changed. Different positioning of the sections with respect to the substrate are possible and, consequently, both top emitting and bottom emitting devices can be realized.

Similar approach can be used for a wavelength-tunable resonant cavity light emitting diode as one another embodiment of the present invention.

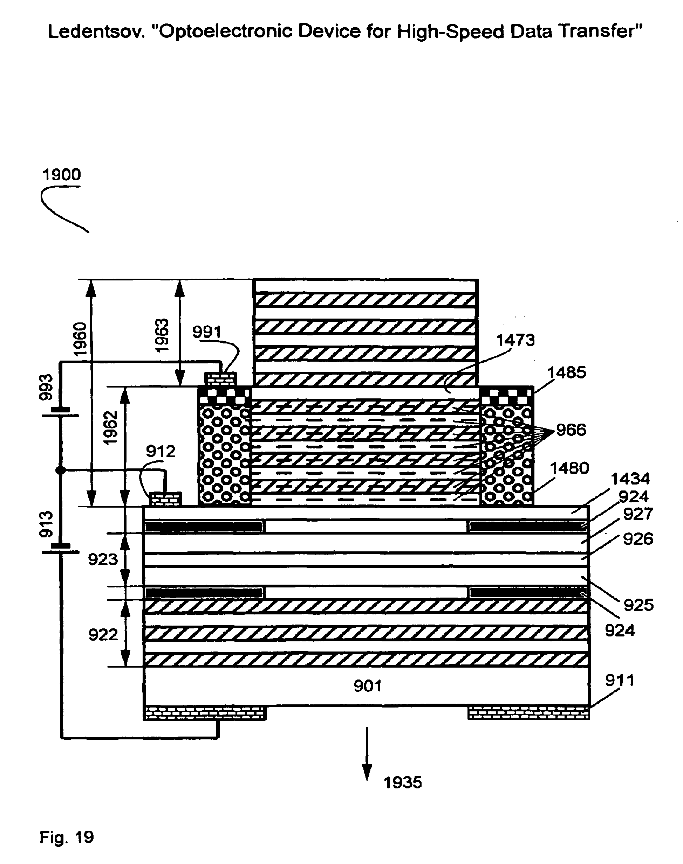

Figure 19 shows a schematic diagram of an electronically wavelength-tunable vertical cavity surface emitting laser (1900), according to one further embodiment of the present invention. The operation of the device (1900) is illustrated in Fig. 18. The second DBR (1960) comprises a tunable section (1962) and a non tunable section (1963). Applying bias (993) to the tunable section (1962) of the second DBR (1960), it is possible to tune the wavelength of the laser light (1935) emitted through the substrate.

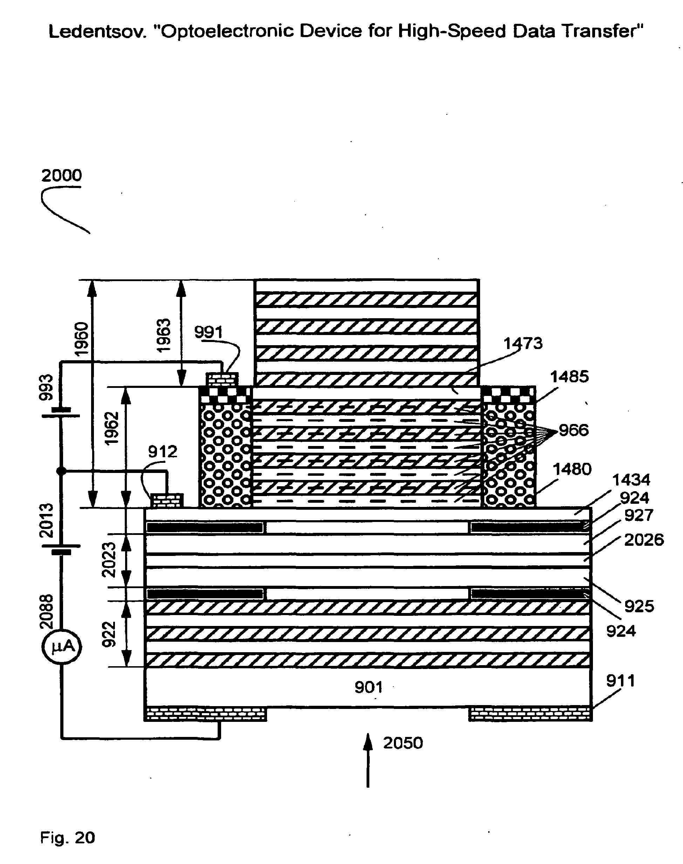

Figure 20 shows a schematic diagram of an electronically wavelength-tunable resonant cavity photodetector (2000). A zero or reverse bias (2013) is applied to the p-n junction in the active cavity (2023). External light (2050) impinging on the device is absorbed by the p-n junction element (2026) resulting in the generation of electron-hole pairs, and, thus, in the generation of a photocurrent which can be measured by a microampermeter (2080). Applying the bias (993) to the tunable section (1962) of the top DBR (1960) tunes the resonance wavelength of the resonance cavity photodetector (2000).

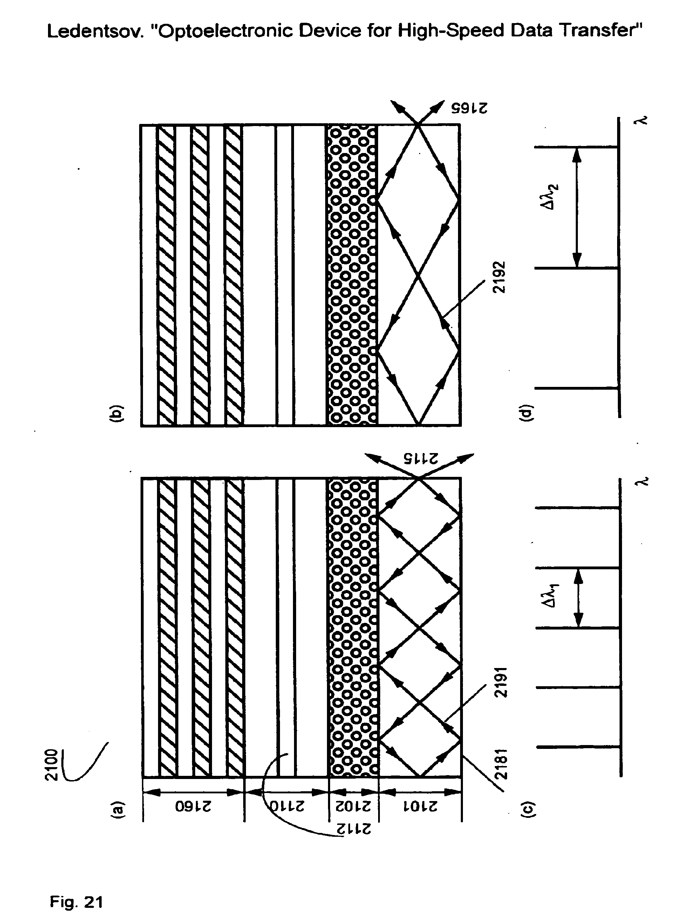

Figure 21 shows a schematic diagram of a Bragg-reflector stopband-tunable leaky laser (2100). Figure 21(a) shows a leaky laser (2100) comprising an active waveguide (2110) with an active region (2112) sandwiched between the bottom reflector (2102) which is preferably an evanescent reflector, or a cladding layer, and a tunable multilayer interference reflector (2160). The laser generates light in a leaky optical mode which leaks into the substrate (2101), is reflected back from the back side of the substrate (2181) forming a tilted optical mode (2191) within the substrate. The light exits (2115) the device forming preferably a two-lobe beam. Necessary conditions for lasing require constructive interference of the laser light propagating from the active region through the substrate to the back surface of the substrate and back to the active region. These conditions are met for certain wavelengths shown schematically as peaks in Fig. 21(c). The spectral interval between the peaks is a function of the leaky angle. By varying the refractive index in the layers of the MIR (2160), the reflectivity of the MIR changes. This changes the leaky angle. Figure 21(b) shows the state of the device with a smaller leaky angle showing the optical mode in the substrate (2192) and the emitted light (2165) for this case. The corresponding spectrum of the allowed optical modes is presented in Fig. 21 (d). In a preferred embodiment, reduction of the transparency of the MIR (2160) results in a weaker confinement of the optical mode in the active waveguide (2110), and thus, in a larger leaky angle. Thus, Figs. 21 (a) and 21(c) correspond to a non-transparent state of the MIR (2160), and Figs. 21(b) and 21(d) correspond to a transparent state of the MIR.

Bragg-reflector stopband-tunable leaky light-emitting diode can be realized in a similar way.

When any optoelectronic device of the present invention allowing the intensity modulation of the emitted light is fabricated, it is possible to control the intensity of the emitted light. A method of the control includes two stages: calibration and control itself.

A method of calibrating the device consists of the following steps:

a) introducing a microampermeter in the same electrical circuit, where the bias is applied to the modulator region, wherein the microampermeter is capable to measure the photocurrent generated in the modulator upon an applied reverse bias;

b) applying a bias to the modulator region and to the light generating element independently with the electric contacts;

c) electrooptically tuning a stopband reflectivity edge wavelength of the multilayer interference reflector with respect to a resonant wavelength of the cavity;

d) varying an optical transmittance of the device, such that an output optical power is varied;

e) measuring the photocurrent in the electric circuit of the modulator section under reverse bias, and measuring the output light power of the device;

f) obtaining the light-photocurrent calibration curves.

Once the device is calibrated, a method of controlling the output power may be used, wherein the method consists of the steps of:

a) applying a bias to the modulator region and to the light generating element independently with the electric contacts;

b) electrooptically tuning a stopband reflectivity edge wavelength of the multilayer interference reflector with respect to a resonant wavelength of the cavity;

c) varying an optical transmittance of the device, such that an output optical power is varied;

d) measuring the photocurrent in the electric circuit of the modulator section under reverse bias; and

e) adjusting the drive current in the circuit of the active element to keep the requested output power of the device using the calibrated light-photocurrent curves.

A lot of modifications can be made. Photonic crystals can be used for better mode control and light extraction efficiency. The surface-emitting devices operating at high angles with respect to normal can be constructed. Different designs of multilayer interference reflectors used as Bragg reflectors can be applied. Multiple sections can be introduced. Photocurrent of the modulator section can be used for failure control or for power adjustment.

Adding further modulator sections enables applications in semiconductor optical amplifiers, frequency converters or lock-in optical amplifiers.

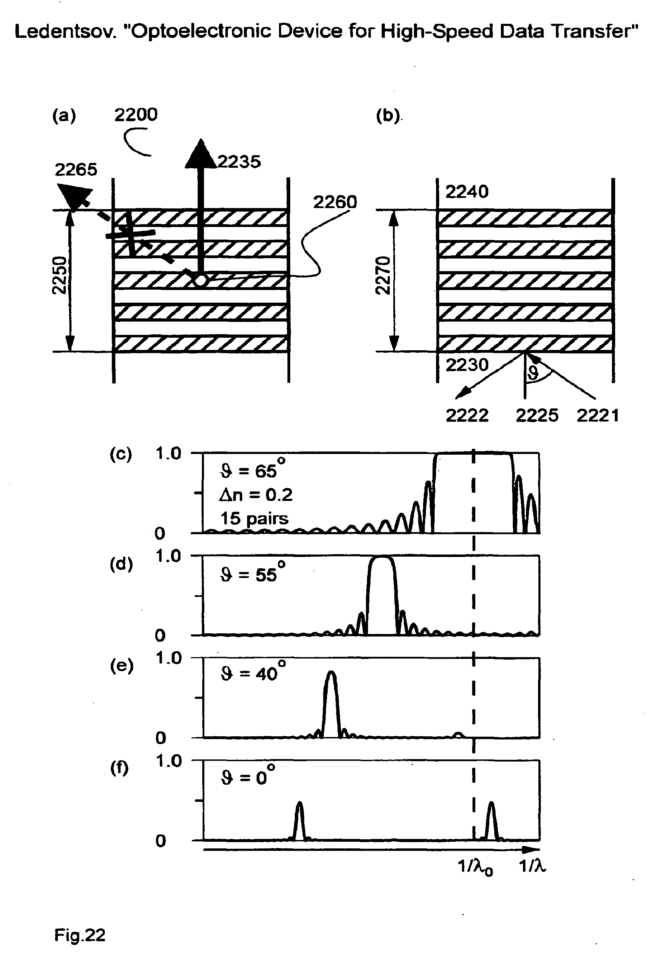

Further embodiments refer to a vertically-integrated device, wherein means are introduced to suppress parasitic optical modes. These vertically integrated devices can be used for both direct and indirect modulation of the intensity of the emitted light. The idea of the suppression of the parasitic modes refers to the optical properties of multilayer structures at an oblique or tilted incidence of light. The basic approach is illustrated schematically in Fig. 22. Figure 22 (a) shows schematically a semiconductor structure (2200), wherein an optical oscillator (2260), emitting light having a certain photon energy which corresponds to the wavelength of light in the vacuum $\lambda_0$, is inserted into a medium (2250) with modulated refractive index, i.e. into a multilayer structure. The multilayer structure (2250) is selected such that light in some directions comes out (2235), whereas light does not come out in some other directions (2265).

Figures 22(b) through 22(f) illustrate the possibility to forbid transmission of light through a multilayer structure in some selected directions. Figure 22(b) shows schematically a periodic multilayer structure (2270) sandwiched between a first medium (2230) and a second medium (2240). Light (2221) impinges on the periodic multilayer structure (2270) at a tilt angle $\vartheta$, is partially reflected back (2222), and partially transmitted. The tilt angle $\vartheta$ is defined with respect to the direction (2225), normal to the planes of the layers in the multilayer structure (2270). Figures 22(c) through 22(f) show prior art calculated reflectivity spectra of a periodic multilayered structure for a few different tilt angles of the propagating transverse electric (TE) electromagnetic wave, as described by A. Yariv and P. Yeh, in Optical Waves in Crystals. Propagation and Control of Laser Radiation, Wiley, 1984, Chapter 6. Light comes from the medium (2230) with a refractive index $n_1$ = 3.6, and the structure includes 15 periods, each period further including one layer of the $\Lambda / 2$ thickness having a low refractive index $n_2$ = 3.4 and one layer of equal $\Lambda/2$ thickness having a high refractive index $n_1$ = 3.6. The medium (2240) behind the periodic structure (2270) also has a refractive index $n_1$ = 3.6. The reflectivity is plotted as a function of $1/\lambda$, where $\lambda$ is the wavelength of the electromagnetic wave in the vacuum. Figures 22(c) through 22(f) reproduce the prior art figures by A. Yariv and P. Yeh (Optical Waves in Crystals. Propagation and Control of Laser Radiation, Wiley, 1984, Chapter 6), where the reflectivity spectra are plotted versus the frequency $\omega$ of the electromagnetic wave, and $\omega$ = $c/\lambda$, where c is the velocity of light in the vacuum.

The major properties of the reflectivity spectra of Figs. 22(c) through 22(f) are as follows. At the normal incidence, $\vartheta$=0, as shown in Fig. 22(f), the reflectivity spectrum reveals narrow spikes of low amplitude. As the angle $\vartheta$ increases, spikes shift towards shorter wavelengths, the amplitude of the spikes increases, and the spikes become broader. This is seen in Fig. 22(e) for $\vartheta$=40° and in Fig. 22(d) for $\vartheta$=55°. Broadened spikes with form stopbands with a reflectivity close to 1. This is seen in Fig. 22(d) for $\vartheta$=55°, and, more pronounced, in Fig. 22(c) for $\vartheta$=65°.

Let the selected wavelengh $\lambda_0$ be in the center of the well pronounced stopband of the reflectivity spectrum of the multilayer structure (2270) at the angle, say, $\vartheta$=65°, as shown in Fig. 4(f). Then light at this wavelength is nearly completely reflected back, and the transmission of the light through this structure is nearly forbidden. Referring again to an oscillator (2260) inserted in a multilayer structure (2250), as shown in Fig. 4(a), one can note the following. Basic properties of multilayered structure persist also in the case, where the source of light, i.e. the optical oscillator (2260) is inserted inside a multilayer structure. This implies that transmission of light through a multilayer structure can be forbidden in some directions, as shown in Fig. 4(a).

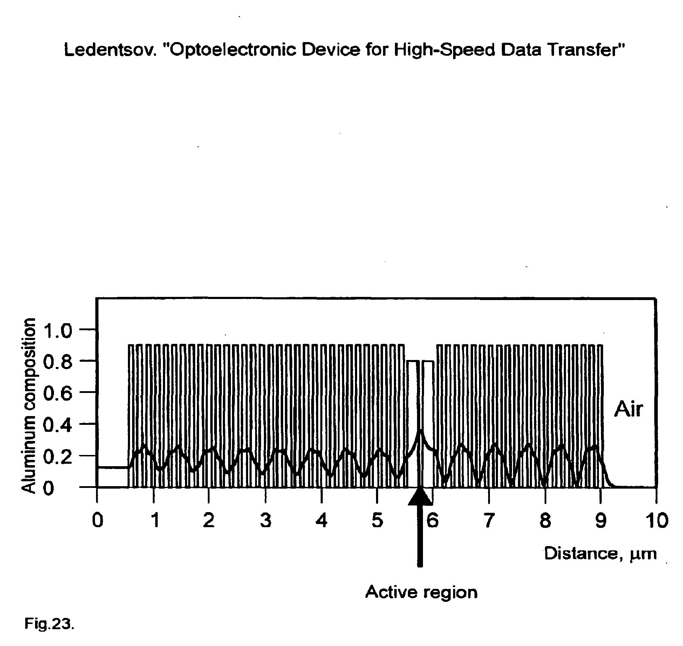

An approach allowing further suppression of parasitic modes in a anti-waveguiding VCSEL is related with the angular distribution of modes shown in Fig. 5(b). Figure 23 shows schematically optical field distribution in one of the tilted modes of Fig. 5(b) having the strongest intensity in the active region. One can see that this mode has an intensity maximum in the active region. For the tilted modes having a low intensity in the active zone the confinement factor is small and the related emission is weak. Thus, it is only a certain range of angles causing most of the parasitic radiative losses. Once the modes having a significant overlap with the active region are suppressed, the radiative losses can be significantly reduced.

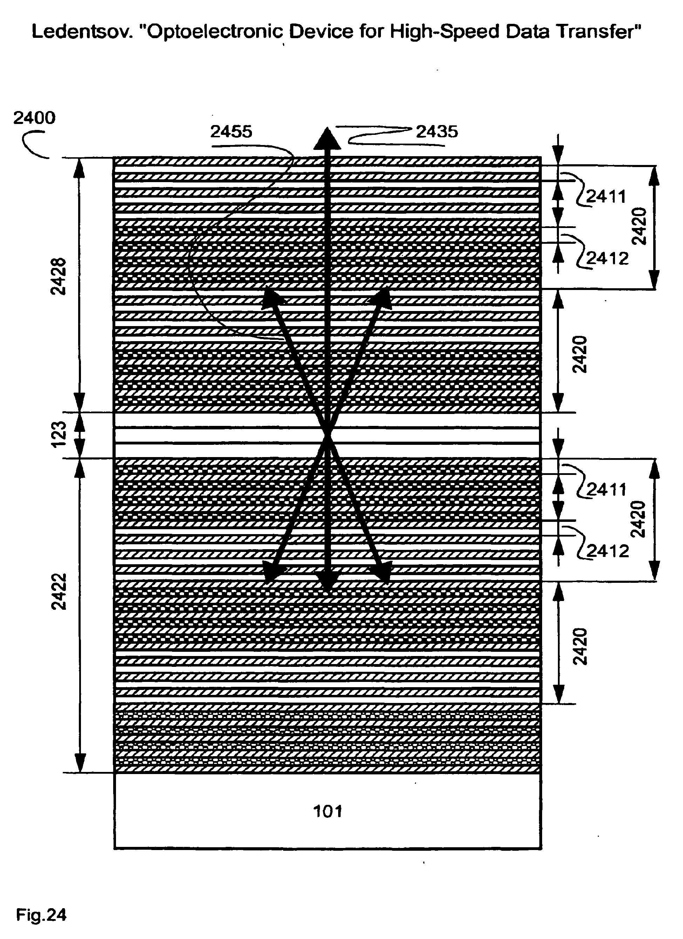

Figure 24 shows a schematic diagram of a vertically integrated optoelectronic device. The device (2400) comprises a light generating element, or a cavity (123) sandwiched between a bottom distributed Bragg reflector (DBR) (2422) and a top DBR (2428). Both the bottom DBR (2422) and the top DBR (2428) have two periodicities of the refractive index thus integrating a number of substructures. In the embodiment of Fig. 24, the two periodicities of the refractive index are realized as follows. The bottom DBR (2422) and the top DBR (2428) comprise a coarse-scale period (2420). Each coarse-scale period (2420) comprise a few layer pairs (2411) realizing a first periodicity and a few layer pairs (2412) realizing a second periodicity. In the particular embodiment of Fig. 24, the first periodicity is realized by four layer pairs (2411) and the second periodicity is realized by four layer pairs (2412). The first periodicity provides VCSEL DBRs to support vertical lasing (2435) and the second periodicity provides a stopband for radiative recombination with emission in the relevant angle range. Apart from the emission in the vertical mode (2435), the device (2400) can emit light in the tilted modes (2455) in a narrow interval of angles close to the direction normal to the surface. The general layout and contact geometry of the device can be similar to that of prior art device of Fig. 1 (b). Prohibition of the parasitic modes increases the efficiency of light extraction and the differential gain of the device, allowing also high speed operation of the device in the regime of the direct modulation of light intensity.

In another embodiment only the top DBR has a double periodicity of the refractive index. And in yet another embodiment only the bottom DBR has a double periodicity of the refractive index.

The number of pairs forming first periodicity and second periodicity can be different from each other as well as be different from four. A preferred number of pairs in each of the periodicities forming a coarse scale period of the DBRs is between two and ten. Another embodiment is possible, where one of the periodicities contain only one period. Thus, e.g., a coarse scale period can contain a few fine-scale periods corresponding to a first periodicity and one period corresponding to a second periodicity. And yet another embodiment is possible, where a coarse scale period contain one period corresponding to a first periodicity and one period corresponding to a second periodicity.

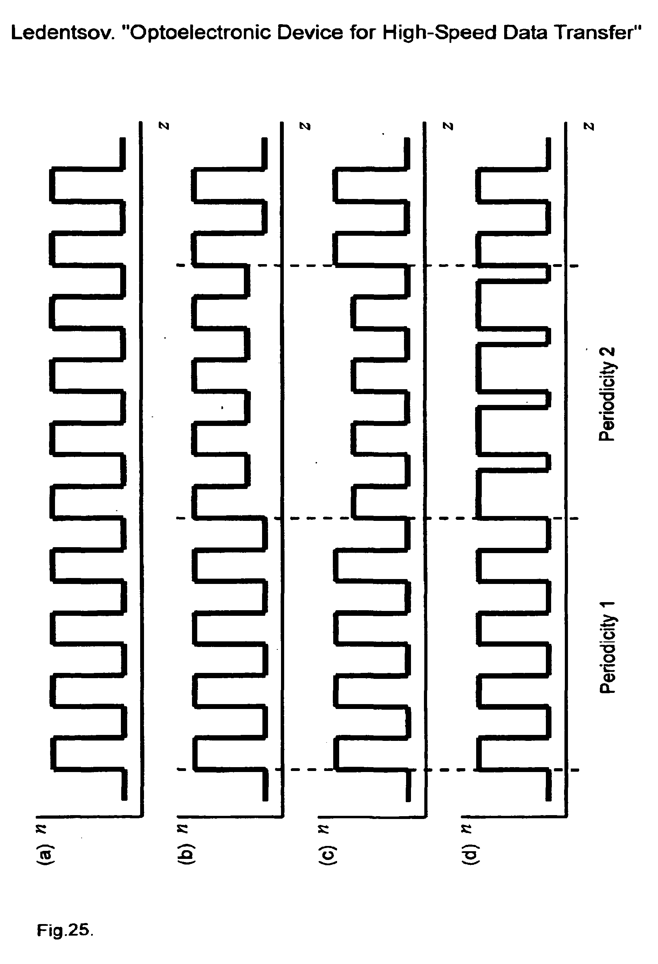

The double periodicity can be realized in different ways. Figure 25 gives a few examples, which may be further extended. For comparison, Figure 25(a) shows schematically the refractive index profile of a single-periodicity DBR in the standard prior-art VCSEL device. Figure 25(b) shows schematically the refractive index profile of a double-periodicity DBR in the device of the embodiment of Fig. 24, where the second periodicity is realized by increasing the refractive index of the low-refractive index layers. Figure 25(c) shows schematically the refractive index profile of a double-periodicity DBR in the device of the embodiment of Fig. 24, where the second periodicity is realized by decreasing the refractive index of the high-refractive index layers. Figure 25(d) shows schematically the refractive index profile of a double-periodicity DBR in the device of the embodiment of Fig. 24, where the second periodicity is realized by changing the relative thickness of the layers in the DBR keeping the same fine-scale periodicity.

Other embodiments include triple or multiple periodicities in the DBRs.

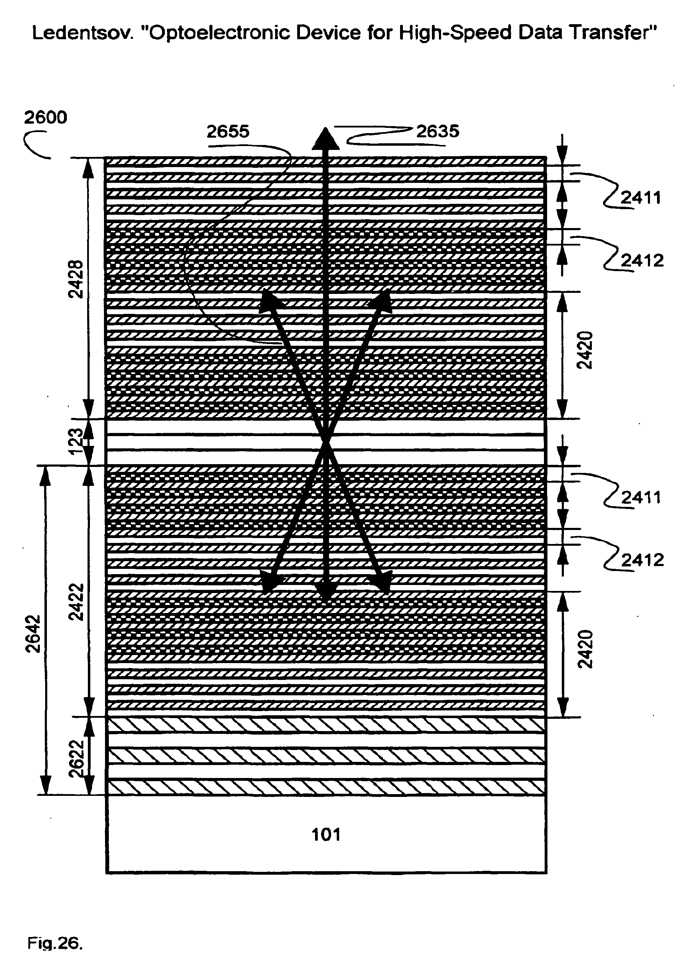

Figure 26 shows a schematic diagram of an optoelectronic device (2600). In addition to the device shown in Fig. 24, the device (2600) comprises a bottom DBR (2642) further comprising a first section (2422) having a double periodicity and a second section (2622) having a different refractive index profile. This part (2622) can be used for further suppression of the tilted modes, or, as opposite to ensuring high reflection of the vertical mode and can itself have double or multiple periodicities. The device (2600) is preferably selected to emit light in the vertical mode (2635) and in tilted modes (2655) in a narrow angle interval close to the direction normal to the surface.

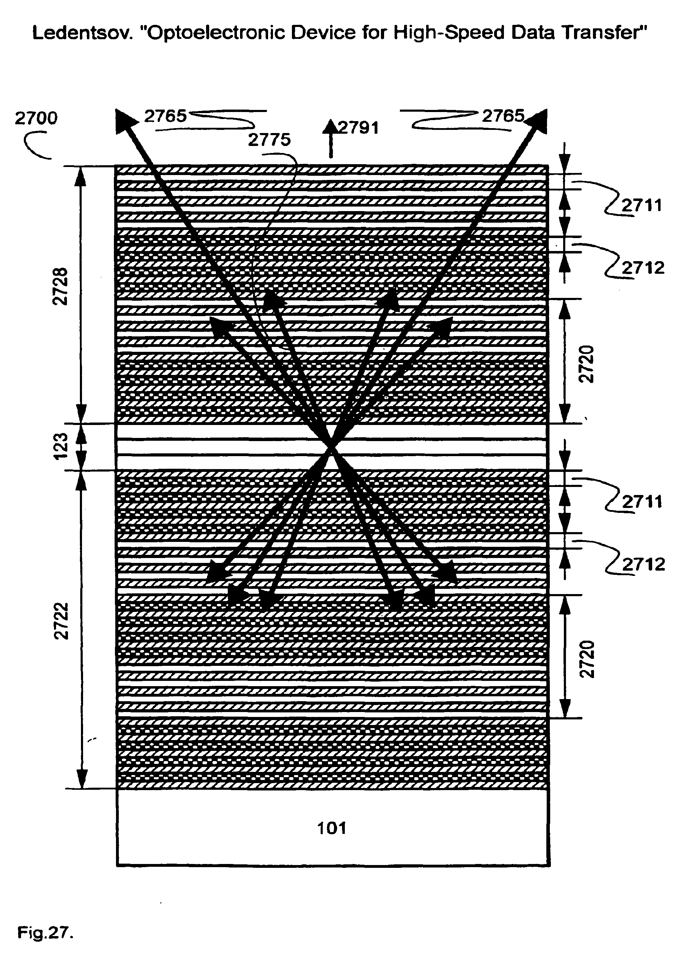

Figure 27 shows a schematic diagram of an optoelectronic device (2700). The device (2700) comprises a cavity (123) sandwiched between a bottom multilayer interference reflector (MIR) (2722) and a top MIR (2728). Both the bottom MIR (2722) and the top MIR (2728) have two periodicities. The two periodicities are realized as follows. Both the bottom MIR (2722) and the top MIR (2728) have a coarse-scale period (2720). Each coarse-scale period (2720) comprises a few layer pairs (2711) realizing a first periodicity and a few layer pairs (2712) realizing a second periodicity. In the particular embodiment (2700) shown in Fig. 27, the first periodicity is realized by four layer pairs (2711) and the second periodicity is realized by four layer pairs (2712). Both the first periodicity and the second periodicity are optimized for tilted emission of the allowed component (2765). Apart from the emission in the optimum direction (2765), emission occurs (2775) also in a certain interval of angles around the optimum direction. Such a design can be favorable for the device operating in a tilted cavity mode. If the emitted radiation has the maximum intensity in a direction tilted with respect to the direction (2791) normal to the surface plane, the emitted light has usually a multi-lobe pattern depending also on the shape of the optical aperture in the surface plane. If the optical aperture in the surface plane has a rectangular shape, the far-field pattern has two or four lobes tilted at the same polar angle with respect to the direction (2791) normal to the surface plane, but at different azimuths. If the optical aperture in the surface plane has a circular shape, the far field has preferably a conical shape corresponding to the emission of light at a certain polar angle and homogeneously distributed over all azimuths.

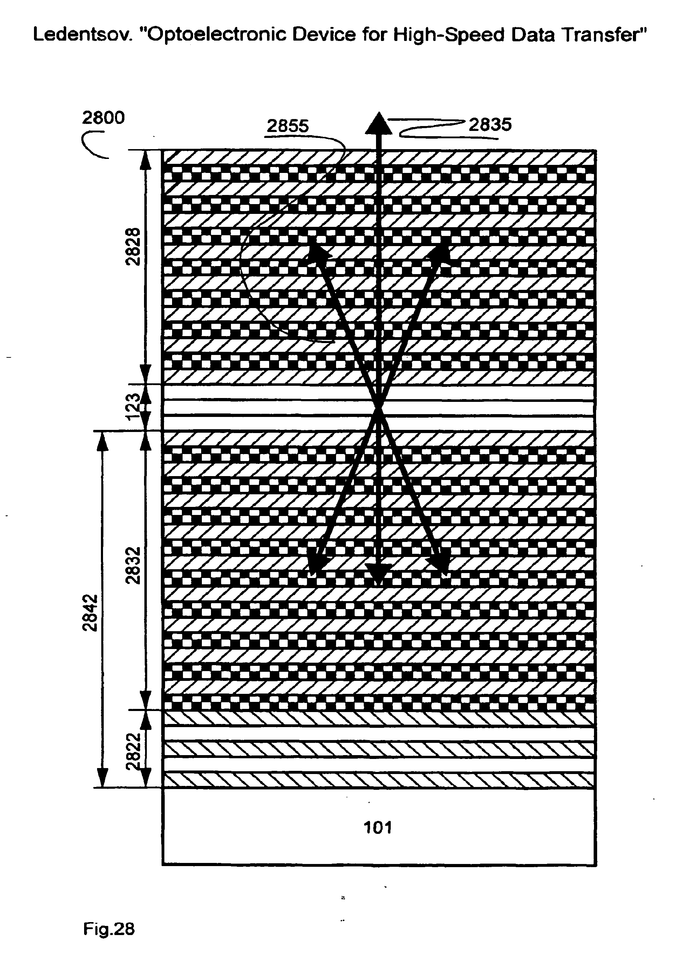

Figure 28 shows a schematic diagram of an optoelectronic device (2800). The device (2800) comprises a cavity (123) sandwiched between a bottom DBR (2842) and a top DBR (2828). The bottom DBR (2842) further comprises a first part (2832) and a second part (2822). The first part (2832) of the bottom DBR (2842) has a single periodicity. The second part (2822) of the bottom DBR (2842) has also a single periodicity. The first part (2832) of the bottom DBR (2842) is selected such that it prohibits parasitic radiative losses at tilted angles. The additional, second part (2822) of the bottom DBR (2842) is used for ensuring high reflectivity of the optical mode propagating in the vertical reflection. The two parts of the bottom DBR (2842) can also be regarded as a different realization of a double periodicity. Light is emitted from the device (2800) in a vertical mode (2835). Some tilted modes (2855) are also emitted at small or moderate tilt angles with respect to the direction normal to the surface plane.

It will be appreciated by those skilled in the art that an optoelectronic device having a cavity sandwiched between two DBRs or MIRs, wherein at least one DBR or MIR has two periodicities, can be realized in different ways. In one further embodiment the emission of light can occur through the substrate. In yet another embodiment light can be extracted via near-field outcoupling. All possible modifications, however, serve the goal of suppressing parasitic tilted modes by applying a special structure with periodic or quasi-periodic refractive index profile.

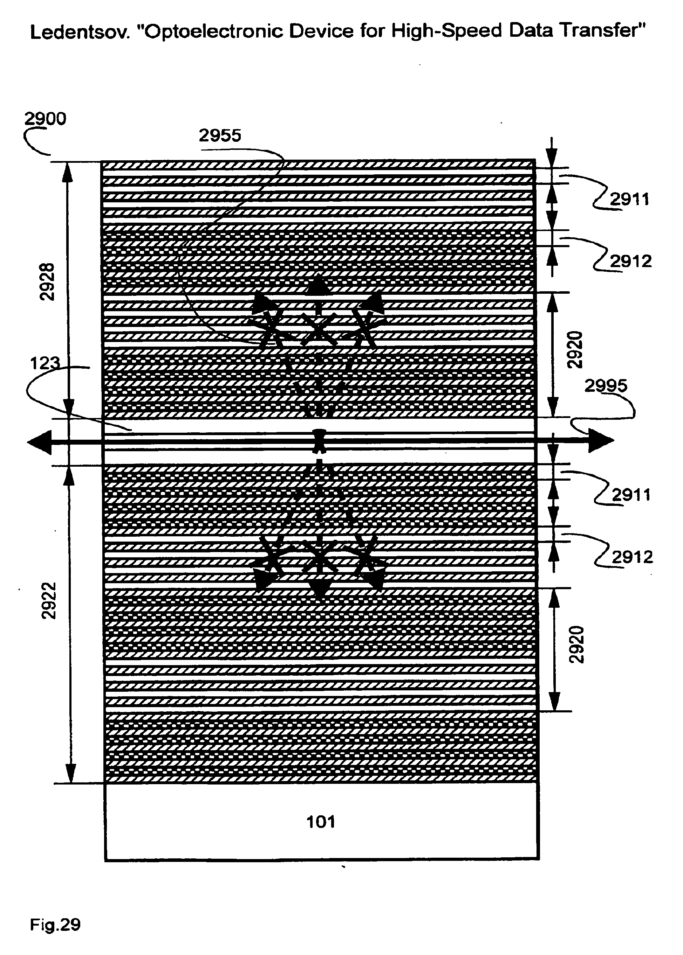

Figure 29 shows a schematic diagram of an optoelectronic device (2900). The device (2900) comprises a cavity (123) sandwiched between a bottom multilayer interference reflector (MIR) (2922) and a top MIR (2928). Both the bottom MIR (2922) and the top MIR (2928) have two periodicities. The two periodicities are realized as follows. Both the bottom MIR (2922) and the top MIR (2928) have a coarse-scale period (2920). Each coarse-scale period (2920) comprises a few layer pairs (2911) realizing a first periodicity and a few layer pairs (2912) realizing a second periodicity. In the particular embodiment (2900) shown in Fig. 29, the first periodicity is realized by four layer pairs (2911) and the second periodicity is realized by four layer pairs (2912). The double periodicity of the multilayer interference reflectors is optimized for in-plane propagation and prohibiting the emission in vertical and tilted directions. Thus, emission in both vertical direction and tilted (2955) directions is suppressed, and emission occurs only in the in-plane optical mode (2995). The suppression of both vertical and tilted modes is very advantageous for edge emitting devices, such as edge-emitting laser diodes and may lead to significant improvement in threshold current, temperature stability and differential gain.

Further embodiment includes an edge-emitting distributed feedback laser. And another embodiment of the present invention is an optoelectronic device operating as a multi-sectional edge-emitting laser.

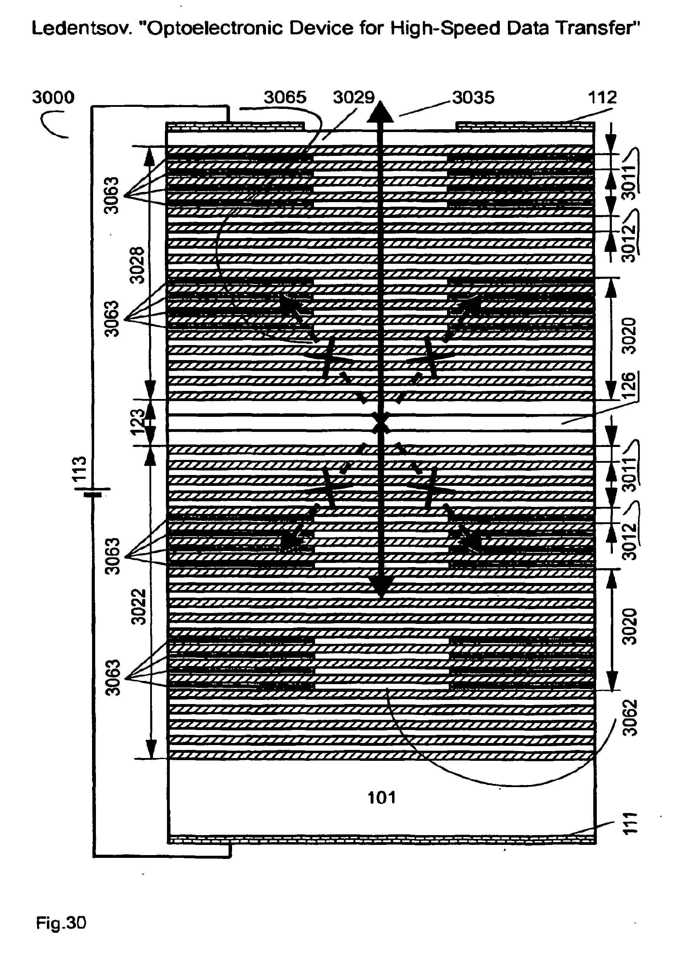

Figure 30 shows a schematic diagram of an optoelectronic device (3000). The device (3000) comprises a cavity (123) sandwiched between the bottom DBR (3022) and the top DBR (3028). The substrate (101) is contiguous to the bottom DBR (3022) from the side opposite to the cavity (123). The bottom contact (111) is mounted on the back side of the substrate (101), i.e. on the side opposite to the bottom DBR (3022). The top contact layer (3029) is contiguous to the top DBR (3028) on the side opposite to the cavity (123). The top contact (112) is mounted on the top contact layer (3029) on the side opposite to the top DBR (3028). The active region (126) is located in the cavity (123). A forward bias (113) is applied to the active region (126) via the bottom contact (111) and the top contact (112). In the embodiment of Fig. 30, the substrate (101) and the bottom DBR (3022) are preferably n-doped, and the bottom contact (111) is the n-contact. The top DBR (3028) and the top contact layer (3029) are preferably p-doped, and the top contact (112) is the p-contact.

Both the bottom DBR (3022) and the top DBR (3028) have a coarse-scale period (3020). Each coarse-scale period (3020) comprises a few layer pairs (3011) realizing a first periodicity and a few layer pairs (3012) realizing a second periodicity. In the particular embodiment (3000) shown in Fig. 30, the first periodicity is realized by four layer pairs (3011) and the second periodicity is realized by four layer pairs (3012). The device (3000) is grown epitaxially on the substrate (101), and the layers of the bottom DBR (3022) and the layers of the top DBR (3028) are grown epitaxially from the materials selected from the group consisting of GaAs, AlAs, and semiconductor alloys GaAlAs. The second periodicity realized by the layer pairs (3012) contain, one layer in each pair, formed from AlAs or GaAlAs with a high A1 content, preferably higher than 90%. The epitaxially grown and processed device is further oxidized such that AlAs layers are partially oxidized and the outer part of these layers form AlO layers, and GaAlAs layers with a high Al content are partially oxidized and the outer part of these layers form GaAlO layers. The oxides form an outer part (3063) of the oxidized layers, whereas semiconductor layers (3062) in the central part of the structure are not oxidized. The oxides GaAlO and AlO are dielectrics, and the current flows through the non-oxidized parts (3062) of the layers.

The main effect of introducing oxide layers is related to their refractive indices. The refractive index contrast in a semiconductor/oxide DBR is significantly higher than that in a pure semiconductor DBR. Thus, for a wavelength close to 980 nm, the refractive index of GaAs equals 3.53, and that of AlAs equals 2.97. At the same time, the refractive index of AlO equals approximately 1.6. Thus, introducing a periodicity in the DBR having a high refractive index contrast enhances the possibility to control the angular distribution of light emission. In the device (3000) the oxide layers in the DBRs suppress the emission of light in the tilted directions (3065), and light is thus preferably emitted in the vertical direction (3035).

Another embodiment is possible, where layers of GaAlAs having a high Al content have different Al content. Then, the oxidation rate of the layers having a higher Al content is higher, and the oxidation depth will be larger. Such layers will have broader oxide areas. This gives an additional possibility to control the angular emission of the optoelectronic device.

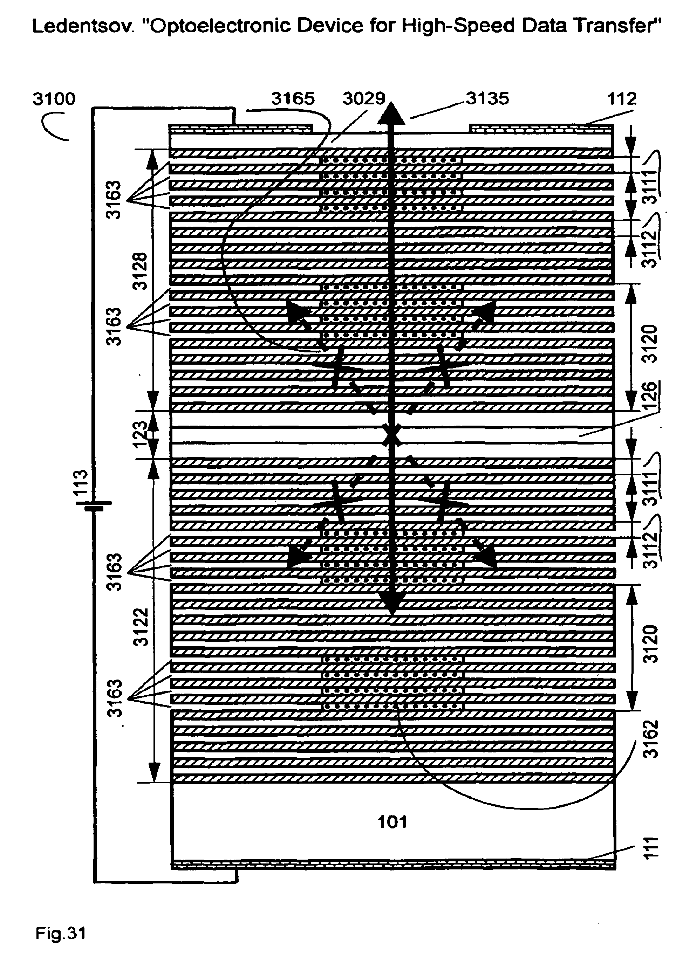

Figure 31 shows a schematic diagram of an optoelectronic device (3100). Both the bottom DBR (3122) and the top DBR (3128) have a coarse-scale period (3120). Each coarse-scale period (3120) comprises a few layer pairs (3111) realizing a first periodicity and a few layer pairs (3112) realizing a second periodicity. In the particular embodiment (3100) shown in Fig. 31, the first periodicity is realized by four layer pairs (3111) and the second periodicity is realized by four layer pairs (3112). The device (3100) is grown epitaxially on the substrate (101), and the layers of the bottom DBR (3122) and the layers of the top DBR (3128) are grown epitaxially from the materials selected from the group consisting of GaAs, AlAs, and semiconductor alloys GaAlAs. The second periodicity realized by the layer pairs (3112) contain, one layer in each pair, formed from AlAs or GaAlAs with a high Al content, preferably higher than 90%. The epitaxially grown and processed device is further oxidized such that AlAs layers are partially oxidized and the outer part of these layers form AlO layers, and GaAlAs layers with a high Al content are partially oxidized and the outer part of these layers form GaAlO layers. The oxides form an outer part of the oxidized layers, whereas semiconductor layers (3162) in the central part of the structure are not oxidized. The oxidized outer parts of the layers are further etched off, forming air gaps (3163). As the refractive index of air is close to 1, the introducing of air gaps enhances the refractive index contrast in the DBRs even further as compared to semiconductor/oxide DBR of Fig. 30. Thus, introducing of air gaps (3163) enhances further the possibility to control the angular distribution of light emission. In the device (3100) the air gaps (3163) in the DBRs suppress the emission of light in the tilted directions (3165), and light is thus preferably emitted in the vertical direction (3135).

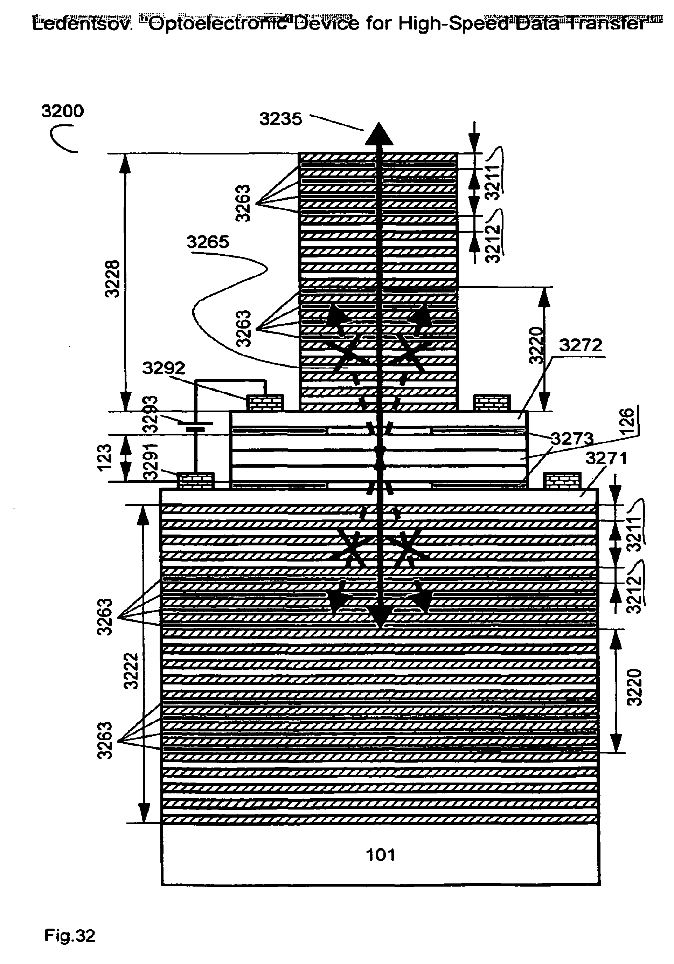

Figure 32 shows a schematic diagram of an optoelectronic device (3200). In this embodiment the oxidized layers of the DBRs are oxidized completely, the DBRs are electrically insulating, and bias is applied to the active region via intracavity contacts. The device (3200) comprises a cavity (123), into which an active region (126) is placed. The cavity (123) is located between the bottom DBR (3222) and the top DBR (3228). The n-doped first current spreading layer (3271) is located between the cavity (123) and the bottom DBR (3222). The p-doped second current spreading layer (3272) is located between the cavity (123) and the top DBR (3228). The current apertures (3273) are located between the cavity (123) and the first current spreading layer (3271) and between the cavity (123) and the second current spreading layer (3272). The first contact (3291), which is an n-contact is mounted on an n-doped first current spreading layer (3271). The second contact (3292), which is a p-contact, is mounted on a p-doped second current spreading layer (3272). A forward bias (3293) is applied to the active region (126) via the first contact (3291) and the second contact (3292). The cavity (123) is preferably undoped or weakly doped. The injection current flows through the n-doped first current spreading layer (3271), the cavity (123) including the active region (126) and the p-doped second current spreading layer (3272). The bottom DBR (3222) and the top DBR (3228) are preferably undoped to reduce the absorption loss of light due to free carrier absorption. The injection current flowing through the active region generates an optical gain in the active region. Thus light is generated in the active region. The bottom DBR (3222) and the top DBR (3228) are selected such to control the angular emission of light.

Both the bottom DBR (3222) and the top DBR (3228) have a coarse-scale period (3220). Each coarse-scale period (3220) comprises a few layer pairs (3211) realizing a first periodicity and a few layer pairs (3212) realizing a second periodicity. In the particular embodiment (3200) shown in Fig. 32, the first periodicity is realized by four layer pairs (3211) and the second periodicity is realized by four layer pairs (3212). The device (3200) is grown epitaxially on the substrate (101), and the layers of the bottom DBR (3222) and the layers of the top DBR (3228) are grown epitaxially from the materials selected from the group consisting of GaAs, AlAs, and semiconductor alloys GaAlAs. The second periodicity realized by the layer pairs (3212) contain, one layer in each pair, formed from AlAs or GaAlAs with a high Al content, preferably higher than 90%. The epitaxially grown and processed device is further oxidized such that AlAs layers are completely oxidized forming AlO layers, and GaAlAs layers with a high Al content are completely oxidized forming GaAlO layers. Oxide layers (3263) have a high refractive index contrast with neighboring semiconductor layers, which enhances the possibility to control the angular distribution of light emission. In the device (3200) the oxide layers in the DBRs suppress the emission of light in the tilted directions (3265), and light is thus preferably emitted in the vertical direction (3235).

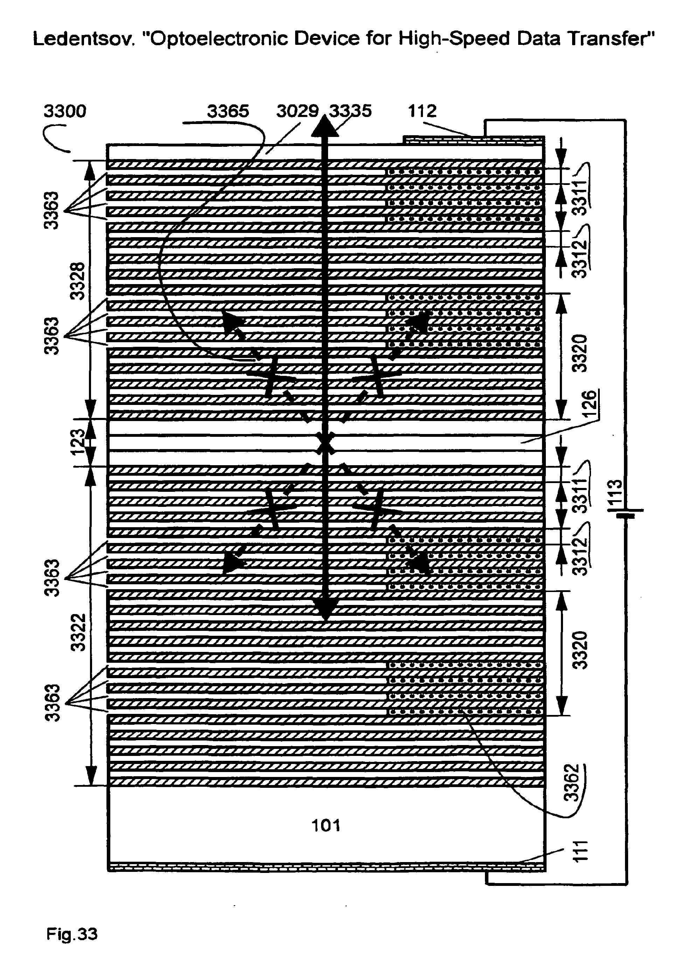

Figure 33 shows a schematic diagram of an optoelectronic device (3300). A cavity (123) in which an active region (126) is placed is sandwiched between a bottom DBR (3322) and a top DBR (3328). Both the bottom DBR (3322) and the top DBR (3328) have a coarse-scale period (3320). Each coarse-scale period (3320) comprises a few layer pairs (3311) realizing a first periodicity and a few layer pairs (3312) realizing a second periodicity. In the particular embodiment (3300) shown in Fig. 33, the first periodicity is realized by four layer pairs (3311) and the second periodicity is realized by four layer pairs (3312). The device (3300) is grown epitaxially on the substrate (101), and the layers of the bottom DBR (3322) and the layers of the top DBR (3328) are grown epitaxially from the materials selected from the group consisting of GaAs, AlAs, and semiconductor alloys GaAlAs. The second periodicity realized by the layer pairs (3312) contain, one layer in each pair, formed from AlAs or GaAlAs with a high Al content, preferably higher than 90%. The epitaxially grown and processed device is further oxidized such that AlAs layers are partially asymmetrically oxidized from one side of the device (3300) forming AlO layers, and GaAlAs layers with a high Al content are partially asymmetrically oxidized from one side of the device (3300) forming GaAlO layers. The oxides are formed on the side, from which the device (3300) is oxidized, and in the central part of the device (3300). The oxidized parts of the layers are further etched off, forming air gaps (3363). The mechanical integrity of the device (3300) is maintained by non-oxidized and non-etched parts (3362) of the layers. The same non-oxidized and non-etched parts (3362) of the layers provide injection current flowing through the active region (126). As the refractive index of air is close to 1, the introducing of air gaps enhances the refractive index contrast in the DBRs, also for the vertical optical mode. Thus, introducing of air gaps (3363) enhances further the possibility to control the angular distribution of light emission. In the device (3300) the air gaps (3363) in the DBRs suppress the emission of light in the tilted directions (3365), and light is thus preferably emitted in the vertical direction (3335).

In another embodiment an optoelectronic device with asymmetrically placed air gaps can be selected such that light is preferably emitted in a tilted direction. In this case, due to the lack of symmetry, single-lobe tilted emission can be obtained. In yet another embodiment of the present invention, an optoelectronic device is oxidized asymmetrically and is not etched off. Asymmetrically positioned oxides layers allow extraction of light in a tilted direction in a single-lobe far-field pattern.

Different embodiments of the present invention are possible referring to all possible ways of fabricating conventional VCSELs. The active medium, realized as a single-layer or a multilayer structure of quantum wells, arrays of quantum wires, arrays of quantum dots or any combination thereof, may contain thin lattice mismatched layers. In another embodiment, the entire structure of the device is grown on a metamorphic (plastically relaxed) buffer, lattice-mismatched to the substrate. The top MIR may be formed of either semiconductor or dielectric layers, or any combination thereof. The possible material combinations are known in the art (e.g., Vertical-Cavity Surface-Emitting Lasers: Design, Fabrication, Characterization, and Applications by C.W. Wilmsen, H. Temkin, L.A. Coldren (editors), Cambridge University Press, 1999, pp. 193-232 ). Further, an optoelectronic device can contain one intracavity contact or two intracavity contacts. If at least one layer in one of the DBRs is a dielectric layer, a corresponding contact must be an intracavity contact, as shown for the device (3200) of the embodiment of Fig. 32. If all layers are semiconductor layers, intracavity contacts may still be used as an option.

It is important to emphasize a big difference between an optoelectronic device having a DBR or a MIR with a double periodicity, and a tilted cavity laser invented by the inventors of the present invention in the US patent application "TILTED CAVITY SEMICONDUCTOR OPTOELECTRONIC DEVICE AND METHOD OF MAKING SAME, US Patent Application 10/943044 by N. Ledentsov and V. Shchukin, filed September 16, 2004. Tilted Cavity Laser (TCL) including Tilted Cavity Surface Emitting Laser is focused on wavelength-stabilized operation realized through optical loss engineering. The optimum wavelength of a TCL is governed by the intersection of the dispersion law of a cavity and the dispersion law of a MIR. The wavelength, at which the intersection occurs, corresponds to the minimum of the optical loss. Lasing occurs at this optimum wavelength, and the operation of the TCL is wavelength-stabilized. Double periodicity may be used in a MIR in one of the embodiments of the TCL to engineer optical loss and to filter out parasitic wavelengths different from the targeted optimum wavelength.

On the contrary, an optoelectronic device, e.g. light-emitting diode or laser diode of the present invention does not include any loss engineering. The wavelength stabilization is not targeted by the present invention. An optoelectronic device of the present invention can operate without wavelength stabilization. In other embodiments of the present invention, the wavelength of light emitted by the device can be stabilized, however not due to the minimum loss criterion in the epitaxial structure, but by a conventional mechanism used in VCSELs, e.g. by a finite lateral oxide aperture (similar to the aperture (3273) in the device (3200)).

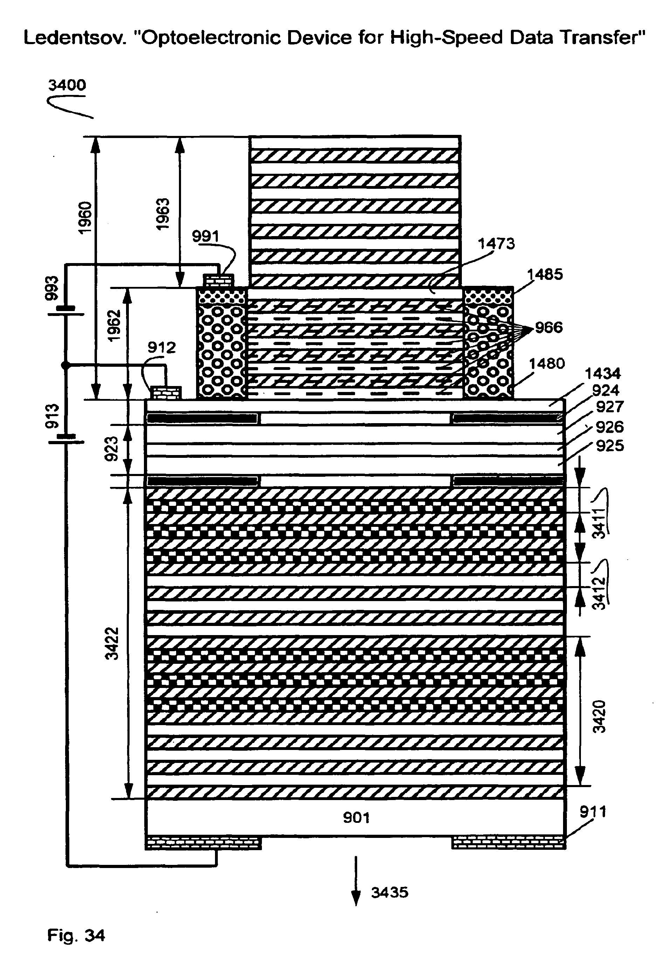

In further embodiments of the present invention, an electrooptically modulated DBR or MIR, on the one hand, and a DBR or a MIR having double periodicity, can be combined to further enhance the functionality of a device. Figure 34 shows a schematic diagram of an electrooptically modulated wavelength tunable vertical cavity surface emitting laser according to yet another embodiment of the present invention. The device (3400) refers to an above described embodiment of the present invention, that of Fig. 19. As compared to the device (1900), the device (3400) comprises the bottom DBR (3422) which has two periodicities. The two periodicities are realized as follows. The bottom DBR (3422) has a coarse-scale period (3420). Each coarse-scale period (3420) comprises a few layer pairs (3411) realizing a first periodicity and a few layer pairs (3412) realizing a second periodicity. In the particular embodiment (3400) shown in Fig. 34, the first periodicity is realized by three layer pairs (3411) and the second periodicity is realized by three layer pairs (3412). Both the first periodicity and the second periodicity are optimized for the vertical emission of the allowed component of light (3435) and suppression of tilted optical modes.

One of the possible operation regimes of the device (3400) is as follows. Suppression of the parasitic optical modes provided by the double periodicity of the bottom DBR (3422) allows a fast direct modulation of the active cavity (923). Thus the intensity of the emitted light is modulated. The modulator section (1962) allows a fast modulation of the wavelength of the emitted light, as also described above for the device (1900). Thus, upon a particular need, the fast modulation of both the intensity and the wavelength of the emitted light is possible.

In another embodiment of the present invention, double periodicity is introduced into an electrooptically-modulated DBR or MIR. Double periodicity can be used in one of non-modulated parts of the electoorptically modulated DBR or MIR. In yet another embodiment of the present invention, the double periodicity is introduced into the modulator element. An alternative embodiment of the present invention is possible, wherein the double periodicity is introduced in all sections of the electrooptically modulated DBR or MIR. In a further embodiment of the present invention, double periodicity is introduced in all DBRs or MIRs of the device.

In another embodiment not being part of the present invention, an optoelectronic device does not contain any cavity, and the active region is placed in one of the layers of a DBR or a MIR. The DBR or the MIR has a double periodicity prohibiting emission of light in an interval of angles tilted with respect to the intentionally selected direction of the light emission.

The following patent and non-patent references are referred to:

U.S. PATENTS

5,574,738. November 12, 1996. Morgan R.A. "Multi-Gigahertz frequency - modulated vertical - cavity surface emitting laser".

6,285,704, September 4,2001. Kullander-Sjoberg, A., Widman, M. "Field modulated vertical cavity surface - emitting laser with internal optical pumping".

6,396,083. May 28, 2002. Ortiz, V., Pelekanos, N. "Optical semiconductor device with resonant cavity tunable in wavelength, application to modulation of light intensity".

6,611,539. August 26, 2003. Ledentsov, N., Shchukin, V. "Wavelength-tunable vertical cavity surface emitting laser and method of making same".

7,031,360. April 18, 2006. Ledentsov, N., Shchukin, V. "Tilted cavity semiconductor laser (TCSL) and method of making same"

7,075,954. July 11, 2006. "Intelligent wavelength division multiplexing systems based on arrays of wavelength tunable lasers and wavelength tunable resonant photodetectors".

US PATENT APPLICATIONS

10/943,044. September 16, 2004. Ledentsov, N., Shchukin, V. "Tilted cavity semiconductor optoelectronic device and method of making same"

11/099,360, April 5, 2005. Ledentsov, N., Shchukin, V. "Optoelectronic device based on an antiwaveguiding cavity"

11/144,482. June 2, 2005. Ledentsov, N., Shchukin, V. "Electrooptically wavelength - tunable resonant cavity optoelectronic device for high speed data transfer"

11/194,181, August 1, 2005. Ledentsov, N., Shchukin, V. "Tilted cavity semiconductor device and method of making same"

11/453,979, June 16,2006, Ledentsov, N., Shchukin, V. "Electrooptically Bragg-reflector stopband-tunable optoelectronic device for high-speed data transfer"

60/814,054, June 16, 2006, Shchukin, V., Ledentsov, N. "Resonant cavity optoelectronic device with suppressed parasitic modes"

OTHER PUBLICATIONS

I. Galbraith, B. Ryvkin "Empirical determination of the electroabsorption coefficient in semiconductors", Journal of Applied Physics. Vol. 74, p. 4145 (1993)

D.S. Chelma et al. "Room Temperature Excitonic Nonlinear Absorption and Refraction in GaAs/AlGaAs Multiple Quantum Well Structures", IEEE Journal of Quantum Electronics, Vol. QE-20 (3), pp. 265-275 (1984)

J.E. Zucker, T.L. Hendrickson, and C.A. Burrus, "Electro-optic phase modulation in GaAs/AlGaAs quantum well waveguides". Applied Physics Letters, Vol. 52 (12), pp. 945-947 (1988)

J.S. Weiner, D.A.B. Miller and D.S. Chemla "Quadratic electro-optic effect due to the quantum-confined Stark effect in quantum wells", Applied Physics Letters, Vol. 50 (13), pp. 842-844 (1987)

J.E. Zucker, ].Bar-Joseph, B.I. Miller, U. Koren, and D.S. Chemla "Quaternary quantum wells for electro-optic intensity and phase modulation at 1.3 and 1.55 $\mu$m". Applied Physics Letters, Vol. 54 (1), pp. 10-12 (1989)

M.P. Earnshow and D.W.E. Alishop, "Electrooptic Effects in GaAs-AlGaAs Narrow Coupled Quantum Wells", IEEE Journal of Quantum Electronics, Vol. 37 (7), pp. 897-904; ibid. Vol. 37 (8), p. 1103 (2001)

L. Chen, K.C. Rajkumar, and A. Madhukar "Optical Absorption and Modulation Behavior of Strained InxGal-xAs/GaAs (100) (x $\leq$ 0.25 ) multiple quantum well structure grown via molecular beam epitaxy", Applied Physics Letters, Vol. 57 (23), pp. 2478-2480 (1990)

Yu.-P. Feng and H.N. Spector, "Exciton energies as a function of electric field: Confined quantum Stark effect", Physical Review B, Vol. 48 (3), pp. 1963-1966 (1993)

W. Batty, D.W.E. Allsopp, "Internal biasing by δ-doping for low-voltage, high-bandwidth quantum well optical modulators", IEEE Photonics Technology Letters, vol. 7 (6), pp. 635-637 (1995).

H. Feng, J.P. Pang, M. Sugiyama, K. Tada, and Y. Nakano, "Field-induced optical effect in a five-step asymmetric coupled quantum well with modified potential" IEEE Journal of Quantum Electronics, Vol. 34 (7), pp. 1197-1208 (1998).

G. Lengel, K.W.Jelley, and R.W.H. Engelmann, "A Semi-Empirical Model for Electroabsorption in GaAs/AlGaAs Multiple Quantum Well Modulator structures", EEE Journal of Quantum Electronics, vol. 74 (2), pp. 296-304 (1990)

T. Suzuki, T. Arakawa, K. Tada, Yu. Imazato, J.-H. Noh, and N. Haneji, "Observation of giant electrorefractive effect in five-layer asymmetric coupled quantum wells (FACQWs)", Japanese Journal of Applied Physics Vol. 43 (12A), pp. L1540-L 1542 (2004).

M.V. Kotlyar, L. O'Faolain, A.B. Krysa, and Th.F. Krauss, "Electrooptic Tuning of InP-Based Microphotonic Fabry-Pérot Filters", Journal of Lightwave Technology, vol. 23 (6), pp. 2369-2374 (2005)

H.C. Casey, Jr. and M.B. Panish, Heterostructure Lasers, Part A, Academic Press, New York, 1978, pp.34-57.

A. Yariv, P. Yeh, Optical Waves in Crystals. Propagation and Control of Laser Radiation, Wiley, (1984), Chapter 6.

Vertical-Cavity Surface-Emitting Lasers: Design, Fabrication. Characterization. and Applications, by C.W. Wilmsen, H. Temkin, L.A. Coldren (editors), Cambridge University Press, 1999, pp. 193-232.

N.N. Ledentsov and V.A. Shchukin "Novel concepts for injection lasers" SPIE Optical Engineering, Volume 41, Issue 12, pp. 3193-3203 (2002)

N. Ledentsov, V.A. Shchukin, S.S. Mikhrin, I.L. Krestnikov, A.V. Kozhukhov, A.R. Kovsh, L.Ya. Karachinsky, M.V. Maximov, I.I. Novikov and Yu.M. Shemyakov "Wavelength-stabilized tilted cavity quantum dot laser" Semiconductor. Science.and Technology, vol. 19, pp. 1183-1188 (2004).

V.A. Shchukin, N.N. Ledentsov, S.S. Mikhrin, I.L. Krestnikov, A.V. Kozhukhov, A.R. Kovsh, L.Ya. Karachinsky, M.V. Maximov, I.I. Novikov, and Yu.M. Shemyakov, "Tilted Cavity Laser". In: Nanomodeling, ed. by A. Lakhtakia and S.A. Maksimenko, Proc. SPIE 5509, pp. 61-71 (2004), SPIE, Belingham, WA.

N.N. Ledentsov, V.A. Shchukin, A.R. Kovsh, S.S. Mikhrin, I.L. Krestnikov, A.V. Kozhukhov, N.Yu. Gordeev, L.Ya. Karachinsky, M.V. Maximov, I.I. Novikov, Yu.M. Shernyakov, "Edge and Surface-Emitting Tilted Cavity Lasers", Proceedings. SPIE 5722, pp. 130-146 (2005).

V.A. Shchukin, N.N. Ledentsov" N.Yu. Gordeevb, L.Ya. Karachinsky, N.V. Kryzhanovskaya, S.M. Kuznetsovb, M.B. Lifshits, M.V. Maximov, I.I. Novikov, Yu.M. Shernyakov, T. Kettler, K. Posilovic, and D. Bimberg, "High brilliance photonic band crystal laser", Proc. SPIE 6350, pp. 635005-1 - 635005-15(2006).

M.B. Lifshits, V.A. Shchukin, N.N. Ledentsov, and D. Bimberg, "Resonance wavelength in planar multilayer waveguides: control and complete suppression of temperature sensitivity", Semiconductor Science and Technology, vol. 22, pp. 380-384 (2007).

## Claims

1. A semiconductor optoelectronic device (900, 1300, 1400, 1500) comprising:

   a) a cavity;
   b) a first multilayer interference reflector (960, 1460, 1560) comprising a modulator region (962, 1462, 1562);
   c) a second multilayer interference reflector (922, 1522);
   d) at least one light generating element (923, 1523) in the cavity comprising a gain region (926, 1526) for generating light when a forward bias is applied to the gain region (926, 1526);
   e) at least three electric contacts (911, 912, 991, 1412, 1491, 1492) for applying bias to the modulator region (962, 1462, 1562) and to the light generating element (923, 1523) independently,
wherein the cavity is arranged between the first multilayer interference reflector and the second multilayer interference reflector (922, 1522) so as to form a resonator having a resonant wavelength,
**characterised in that**
the first multilayer interference reflector (960, 1460, 1560) comprises:

> i) a tunable part forming the modulator region (962, 1462, 1562); and
> ii) a non-tunable part (961, 1461, 1561) located between the cavity and the tunable part, and

wherein the modulator region (962, 1462, 1562) is arranged to change its refractive index by an electrooptical effect by varying the bias applied to the modulator region (962, 1462, 1562), so that a reflectivity stopband edge wavelength of the tunable part of the first multilayer interference reflector (960, 1460, 1560) is electrooptically tuned; and
wherein varying the bias applied to the modulator region (962, 1462, 1562) shifts the stopband edge wavelength from a spectral position on a short wavelength side of the resonant wavelength to a spectral position on a long wavelength side of the resonant wavelength and varies an optical transmittance of the first multilayer interference reflector.

2. A semiconductor optoelectronic device (1900, 3400) comprising:

> a) a cavity;
> b) a first multilayer interference reflector (1960) comprising a modulator region;
> c) a second multilayer interference reflector (922);
> d) at least one light generating element (923) in the cavity comprising a gain region (926) for generating light when a forward bias is applied to the gain region;
> e) at least three electric contacts (911, 912, 991) for applying bias to the modulator region and to the light generating element (923) independently,
> wherein the cavity is arranged between the first multilayer interference reflector and the second multilayer interference reflector (922) so as to form a resonator having a resonant wavelength,
> **characterised in that**
> the first multilayer interference reflector (1960) comprises:

>> i) a tunable part (1962) forming the modulator region; and
>> ii) a non-tunable part (1963),

> wherein the tunable part (1962) is located between the cavity and the non-tunable part (1963); and
> wherein the modulator region is arranged to change its refractive index by an electrooptical effect by varying the bias applied to the modulator region, so that a reflectivity stopband edge wavelength of the tunable part (1962) of the first multilayer interference reflector (1960) is electrooptically tuned; and wherein varying the bias applied to the modulator region switches the tunable part (1962) of the first multilayer interference reflector (1960) from a state in which it is reflective at the resonant wavelength to a state in which it is transparent at that wavelength so that an effective thickness of the cavity is changed and the resonant wavelength is tuned.

3. The semiconductor optoelectronic device of claim 1 or 2, wherein the modulator region (962,1462, 1562) is arranged to tune the reflectivity stopband wavelength of the tunable part of the first multilayer interference reflector (960,1460,1560,1960) with respect to the resonant wavelength using a quantum confined Stark effect by applying a reverse bias to tune a component of a refractive index of the modulator region (962, 1462, 1562) resonant to the reflectivity stopband wavelength of the tunable part of the first multilayer interference reflector.

4. The semiconductor optoelectronic device of claim 1, wherein the modulator region (962, 1462, 1562 is arranged tune the reflectivity stopband wavelength of the tunable part of the first multilayer interference reflector (960, 1460,1560) with respect to the resonant wavelength using an exciton bleaching effect by injection of nonequilibrium carriers by applying a forward bias.

5. The semiconductor optoelectronic device of claim 1 or 2, wherein the modulator region (962,1462, 1562) is arranged to tune the reflectivity stopband wavelength of the tunable part of the first multilayer interference reflector (960, 1460,1560) with respect to the resonant wavelength via an injection of electron-hole plasma by applying a forward bias.

6. The semiconductor optoelectronic device of claim 1, wherein a modulation of a refractive index of the modulator region (962, 1462, 1562) changes the reflectivity stopband wavelength of the tunable part of the first multilayer interference reflector (960, 1460, 1560) with respect to the resonant wavelength , such that in use, the output optical power is modulated.

7. The semiconductor optoelectronic device of claim 1 or 2, wherein a population inversion is realizable in the gain region (926, 1526), such that, in use, the gain overcomes the overall losses enabling lasing.

8. The semiconductor optoelectronic device of claim 6, wherein the device is selected from the group consisting of:

   a) a vertical cavity surface emitting laser; and
   b) a tilted cavity laser.

9. The semiconductor optoelectronic device of claim 1 or 2, wherein at least one element of the device is formed of materials selected from the group consisting of:

   i) III-V semiconductor materials; and
   ii) alloys based on III-V semiconductor materials;
   wherein the III-V semiconductor materials are selected from the group of binary compounds of an element A, selected from the group consisting of Al, Ga, and In; and an element B, selected from the group consisting ofN, P, As, and Sb.


**Patentansprüche**

1. Optoelektronische Halbleitervorrichtung (900, 1300, 1400, 1500), welche aufweist:

   a) eine Kavität,
   b) einen ersten Mehrschichtinterferenzspiegel (960, 1460, 1560), welcher einen Modulatorbereich (962, 1462, 1562) aufweist,
   c) einen zweiten Mehrschichtinterferenzspiegel (922, 1522),
   d) mindestens ein lichterzeugendes Element (923, 1523) in der Kavität, welches einen Verstärkungsbereich (926, 1526) zum Erzeugen von Licht aufweist, wenn eine Vorwärtsspannung an den Verstärkungsbereich (926, 1526) angelegt wird,
   e) mindestens drei elektronische Kontakte (911, 912, 991, 1412, 1491, 1492) zum unabhängigen Anlegen von Spannung an den Modulatorbereich (962, 1462, 1562) und an das lichterzeugende Element (923, 1523),
   wobei die Kavität zwischen dem ersten Mehrschichtinterferenzspiegel und dem zweiten Mehrschichtinterferenzspiegel (922, 1522) so angeordnet ist, dass sie einen Resonator mit einer Resonanzwellenlänge bildet,
   **dadurch gekennzeichnet, dass**
   der erste Mehrschichtinterferenzspiegel (960, 1460, 1560) aufweist:

      i) einen abstimmbaren Teil, der den Modulatorbereich (962, 1462, 1562) bildet, und
      ii) einen nicht abstimmbaren Teil (961, 1461, 1561), der zwischen der Kavität und dem abstimmbaren Teil angeordnet ist, und

   wobei der Modulatorbereich (962, 1462, 1562) so eingerichtet ist, dass sich sein Brechungsindex durch einen elektrooptischen Effekt ändert, indem die Spannung, die an den Modulatorbereich (962, 1462, 1562) angelegt wird, geändert wird, sodass eine Reflexionsstoppbandkantenwellenlänge des abstimmbaren Teils des ersten Mehrschichtinterferenzspiegels (960, 1460, 1560) elektrooptisch eingestellt wird, und
   wobei ein Varüeren der an den Modulatorbereich (962, 1462, 1562) angelegten Spannung die Stoppbandkantenwellenlänge aus einer spektralen Position auf einer kurzwellenlängigen Seite der Resonanzwellenlänge in eine spektrale Position auf einer langwellenlängigen Seite der Resonanzwellenlänge verschiebt und eine optische Durchlässigkeit des ersten Mehrschichtinterferenzspiegels ändert.

2. Optoelektronische Halbleitervorrichtung (1900, 3400), welche aufweist:

   a) eine Kavität,
   b) einen ersten Mehrschichtinterferenzspiegel (1960), welcher einen Modulatorbereich aufweist,

c) einen zweiten Mehrschichtinterferenzspiegel (922),

d) mindestens ein lichterzeugendes Element (923) in der Kavität, welches einen Verstärkungsbereich (926) zum Erzeugen von Licht aufweist, wenn eine Vorwärtsspannung auf den Verstärkungsbereich angelegt wird,

e) mindestens drei elektronische Kontakte (911, 912, 991) zum unabhängigen Anlegen von Spannung an den Modulatorbereich und an das lichterzeugende Element (923),

wobei die Kavität zwischen dem ersten Mehrschichtinterferenzspiegel und dem zweiten Mehrschichtinterferenzspiegel (922) so angeordnet ist, dass sie einen Resonator bildet, der eine Resonanzwellenlänge aufweist, **dadurch gekennzeichnet, dass** der erste Mehrschichtinterferenzspiegel (1960) aufweist:

i) einen abstimmbaren Teil (1962), der den Modulatorbereich bildet, und

ii) einen nicht abstimmbaren Teil (1963),

wobei der abstimmbare Teil (1962) zwischen der Kavität und dem nicht abstimmbaren Teil (1963) angeordnet ist, und

wobei der Modulatorbereich so eingerichtet ist, dass sich sein Brechungsindex durch einen elektrooptischen Effekt ändert, indem die Spannung, die an den Modulatorbereich angelegt wird, geändert wird, sodass eine Reflexionsstoppbandkantenwellenlänge des abstimmbaren Teils (1962) des ersten Mehrschichtinterferenzspiegels (1960) elektrooptisch abgestimmt wird, und

wobei ein Variieren der an den Modulatorbereich angelegten Spannung den abstimmbaren Teil (1962) des ersten Mehrschichtinterferenzspiegels (1960) aus einem Zustand, in dem er bei der Resonanzwellenlänge reflektiert, in einen Zustand, in welchem er bei dieser Wellenlänge transparent ist, umschaltet, sodass eine effektive Dicke der Kavität verändert wird und die Resonanzwellenlänge abgestimmt wird.

3. Optoelektronische Halbleitervorrichtung nach Anspruch 1 oder 2, wobei der Modulatorbereich (962, 1462, 1562) so eingerichtet ist, dass er die Reflexionsstoppbandkantenwellenlänge des abstimmbaren Teils des ersten Mehrschichtinterferenzspiegels (960, 1460, 1560, 1960) in Bezug auf die Resonanzwellenlänge abstimmt, wobei ein Quanten-Confinement-Stark-Effekt durch Anlegen einer Umkehrspannung verwendet wird, um einen Bestandteil eines Brechungsindexes des Modulatorbereichs (962, 1462, 1562) resonant mit der Reflexionsstoppbandwellenlänge des abstimmbaren Teils des ersten Mehrschichtinterferenzspiegels abzustimmen.

4. Optoelektronische Halbleitervorrichtung nach Anspruch 1, wobei der Modulatorbereich (962, 1462, 1562) so eingerichtet ist, dass er die Reflexionstoppbandkantenwellenlänge des abstimmbaren Teils des ersten Mehrschichtinterferenzspiegel s (960, 1460, 1560) in Bezug auf die Resonanzwellenlänge abstimmt, indem ein Exziton-Bleicheffekt durch Injizieren eines Nicht-Gleichgewichtsladungsträgers durch Anlegen einer Vorwärtsspannung verwendet wird.

5. Optoelektronische Halbleitervorrichtung nach Anspruch 1 oder 2, wobei der Modulatorbereich (962, 1462, 1562) so eingerichtet ist, dass er die Reflexionsstoppbandkantenwellenlänge des abstimmbaren Teils des ersten Mehrschichtinterferenzspiegels (960, 1460, 1560) in Bezug auf die Resonanzwellenlänge abstimmt durch Injizieren eines Elektronenlochplasmas durch Anlegen einer Vorwärtsspannung.

6. Optoelektronische Halbleitervorrichtung nach Anspruch 1, wobei eine Modulation eines Brechungsindexes des Modulatorbereichs (962, 1462, 1562) die Reflexionsstoppbandkantenwellenlänge des abstimmbaren Teils des ersten Mehrschichtinterferenzspiegels (960, 1460, 1560) in Bezug auf die Resonanzwellenlänge ändert, sodass die optische Ausgangsleistung moduliert wird.

7. Optoelektronische Halbleitervorrichtung nach Anspruch 1 oder 2, wobei eine Besetzungsinversion dadurch in dem Verstärkungsbereich (926, 1526) erreicht wird, sodass im Betrieb die Verstärkung den Gesamtverlust übersteigt und dadurch ein Lasen ermöglicht wird.

8. Optoelektronische Halbleitervorrichtung nach Anspruch 6, wobei die Vorrichtung ausgewählt ist aus der Gruppe, bestehend aus:

a) einem oberflächenemittierenden Diodenlaser mit vertikaler Kavität, und

b) einem Laser mit verkippter Kavität.

9. Optoelektronische Halbleitervorrichtung nach Anspruch 1 oder 2, wobei mindestens ein Element der Vorrichtung aus Materialien gebildet ist, die ausgewählt sind aus der Gruppe, bestehend aus:

i) III-V Halbleitermaterialien und

ii) Gemischen basierend auf III-V Halbleitermaterialien,

wobei die III-V Halbleitermaterialien ausgewählt sind aus der Gruppe aus binären Komponenten eines Elementes A, ausgewählt aus der Gruppe, bestehend aus Al, Ga und In und eines Elementes B, ausgewählt aus der Gruppe, bestehend aus N, O, As und Sb.

## Revendications

1. Dispositif optoélectronique à semi-conducteurs (900, 1300, 1400, 1500) comprenant :

a) une cavité ;

b) un premier réflecteur d'interférences multicouche (960, 1460, 1560) comprenant une région formant modulateur (962, 1462, 1562) ;

c) un deuxième réflecteur d'interférences multicouche (962, 1522) ;

d) au moins un élément de génération de lumière (923, 1523) situé dans la cavité et comprenant une région de gain (926, 1526) pour générer de la lumière lorsqu'une polarisation directe est appliquée sur la région de gain (926, 1526) ;

e) au moins trois contacts électriques (911, 912, 991, 1412, 1491, 1492) pour appliquer une polarisation à la région formant modulateur (962, 1462, 1562) et à un élément de génération de lumière (923, 1523) indépendamment,

dans lequel la cavité est disposée entre le premier réflecteur d'interférences multicouche et le deuxième réflecteur d'interférences multicouche (962, 1522) de manière à former un résonateur présentant une longueur d'onde de résonance,

**caractérisé en ce que**

le premier réflecteur d'interférences multicouche (960, 1460, 1560) comprend :

i) une partie accordable constituant la région formant modulateur (962, 1462, 1562) ; et

ii) une partie non accordable (961, 1461, 1561) située entre la cavité et la partie accordable, et

dans lequel la région formant modulateur (962, 1462, 1562) est disposée de façon à ce que son index de réfraction soit modifié par un effet électro-optique par variation de la polarisation appliquée à la région formant modulateur (962, 1462, 1562), de sorte qu'une longueur en bordure d'une bande éliminée de réflexivité de la partie accordable du premier réflecteur d'interférences multicouche (960, 1460, 1560) est accordée de manière électro-optique ; et

dans lequel la variation de la polarisation appliquée à la région formant modulateur (962, 1462, 1562) décale la longueur d'onde en bordure de la bande éliminée d'une position spectrale sur un court côté de longueur d'onde de la longueur d'onde de résonance vers une position spectrale sur un long côté de longueur d'onde de la longueur d'onde de résonance et faisant varier un facteur de transmission optique du premier réflecteur d'interférences multicouche.

2. Dispositif optoélectronique à semi-conducteurs (1900, 3400) comprenant :

a) une cavité ;

b) un premier réflecteur d'interférences multicouche (1960) comprenant une région formant modulateur (922) ;

c) un deuxième réflecteur d'interférences multicouche (922) ;

d) au moins un élément de génération de lumière (923) situé dans la cavité et comprenant une région de gain (926) pour générer de la lumière lorsqu'une polarisation directe est appliquée sur la région de gain ;

e) au moins trois contacts électriques (911, 912, 991) pour appliquer une polarisation à la région formant modulateur et à un élément de génération de lumière (923) indépendamment,

dans lequel la cavité est disposée entre le premier réflecteur d'interférences multicouche et le deuxième réflecteur d'interférences multicouche (922) de manière à former un résonateur présentant une longueur d'onde de résonance,

**caractérisé en ce que**

le premier réflecteur d'interférences multicouche (1960) comprend :

i) une partie accordable (1962) constituant la région formant modulateur ; et

ii) une partie non accordable (1963)

la partie accordable (1962) étant située entre la cavité et la partie non accordable (1963), et

dans lequel la région formant modulateur est disposée de façon à ce que son index de réfraction soit modifié par un effet électro-optique par variation de la polarisation appliquée à la région formant modulateur, de sorte qu'une longueur en bordure d'une bande éliminée de réflexivité de la partie accordable (1962) du premier réflecteur d'interférences multicouche (1960) est accordée de manière électro-optique ; et

dans lequel la variation de la polarisation appliquée à la région formant modulateur commute la partie accordable (1962) du premier réflecteur d'interférences multicouche (1960) d'un état dans lequel il est réfléchissant à la longueur d'onde de résonance dans un état dans lequel il est transparent à cette longueur d'onde de sorte qu'une épaisseur effective de la cavité est modifiée et la longueur d'onde de résonance est accordée.

3. Dispositif optoélectronique à semi-conducteurs selon la revendication 1 ou 2, dans lequel la région formant modulateur (962, 1462, 1562) est disposée de façon à accorder la longueur d'onde de la bande éliminée de réflexivité de la partie accordable du premier réflecteur d'interférences multicouche (960, 1460, 1960) par rapport à la longueur d'onde de résonance utilisant un effet Stark confiné quantiquement en appliquant une polarisation inverse pour accorder une composante d'un index de réfraction de la région formant modulateur (962, 1462, 1562) résonnant à la longueur d'onde de bande éliminée de réflexivité de la partie accordable du premier réflecteur d'interférences multicouche.

4. Dispositif optoélectronique à semi-conducteurs selon la revendication 1 ou 2, dans lequel la région formant modulateur (962, 1462, 1562) est disposée de façon à accorder la longueur d'onde de la bande éliminée de réflexivité de la partie accordable du premier réflecteur d'interférences multicouche (960, 1460, 1960) par rapport à la longueur d'onde de résonance utilisant un effet de blanchiment excitonique en appliquant une polarisation inverse par injection de porteurs de non-équilibre par application d'une polarisation directe.

5. Dispositif optoélectronique à semi-conducteurs selon la revendication 1 ou 2, dans lequel la région formant modulateur (962, 1462, 1562) est disposée de façon à accorder la longueur d'onde de la bande éliminée de réflexivité de la partie accordable du premier réflecteur d'interférences multicouche (960, 1460, 1560) par rapport à la longueur d'onde de résonance via une injection de plasma d'électrons-trous par application d'une polarisation directe.

6. Dispositif optoélectronique à semi-conducteurs selon la revendication 1, dans lequel une modulation d'un index de réfraction de la région formant modulateur (962, 1462, 1562) modifie la longueur d'onde de la bande éliminée de réflexivité de la partie raccordable du premier réflecteur d'interférence multicouche (960, 1460, 1560) par rapport à la longueur d'onde de résonance de sorte que, en utilisation, la puissance optique de sortie est modulée.

7. Dispositif optoélectronique à semi-conducteurs selon la revendication 1 ou 2, dans lequel une inversion de population est réalisée dans la région de gain (926, 1526) de sorte que, en utilisation, le gain surmonte les pertes totales permettant l'effet laser.

8. Dispositif optoélectronique à semi-conducteurs selon la revendication 6, dans lequel le dispositif est sélectionné dans le groupe constitué :

   a) d'un laser à cavité verticale émettant par la surface ; et
   b) d'un laser à cavité inclinée.

9. Dispositif optoélectronique à semi-conducteurs selon la revendication 1 ou 2, dans lequel au moins un élément du dispositif est formé de matériaux sélectionnés dans le groupe constitué :

   i) des matériaux semi-conducteurs III-V ; et
   ii) d'alliages à base de matériaux semi-conducteurs III-V ;
   dans lequel les matériaux semi-conducteurs III-V sont sélectionnés dans le groupe de composés binaires d'un élément A, sélectionné dans le groupe constitué de Al, Ga, et In ; et d'un élément B, sélectionné dans le groupe constitué de N, P, As et Sb.

Ledentsov. "Optoelectronic Device for High-Speed Data Transfer"

(a) 100

112
109
108
116
107
105
113   103   115
104
106
117  102
101
111

(b) 120

135   132
112
129
128
124
127
123   126
125
124
113
122
101
111

Fig. 1. Prior Art

Ledentsov. "Optoelectronic Device for High-Speed Data Transfer"

Fig.2.

Ledentsov. "Optoelectronic Device for High-Speed Data Transfer"

Fig.3.

Ledentsov. "Optoelectronic Device for High-Speed Data Transfer"

Fig.4.

Ledentsov. "Optoelectronic Device for High-Speed Data Transfer"

Fig.5

Ledentsov. "Optoelectronic Device for High-Speed Data Transfer"

Fig. 6.

Ledentsov. "Optoelectronic Device for High-Speed Data Transfer"

Fig. 7.

Ledentsov. "Optoelectronic Device for High-Speed Data Transfer"

(a)

Substrate | 1st DBR | First cavity | 2nd DBR | Filter | 3rd DBR | Air

Active region — Modulator

(b)

Modulator is switched to the resonant state

(c)

Modulator is switched to a non-resonant state

Fig. 8.

Ledentsov. "Optoelectronic Device for High-Speed Data Transfer"

Fig. 9.

Ledentsov. "Optoelectronic Device for High-Speed Data Transfer"

Fig. 10.

Ledentsov. "Optoelectronic Device for High-Speed Data Transfer"

Fig. 11.

Ledentsov. "Optoelectronic Device for High-Speed Data Transfer"

(a)

Tunable-stopband
Bragg reflector

cavity

active
DBR

Substrate

Air

Exit media

1st DBR    2nd DBR

Active region

(b)

Bragg Reflector is switched to the transparent state

light out

(c)

Bragg Reflector is switched to the non-transparent state

light out

Fig. 12.

Ledentsov. "Optoelectronic Device for High-Speed Data Transfer"

Fig. 13.

Ledentsov. "Optoelectronic Device for High-Speed Data Transfer"

Fig. 14.

Ledentsov. "Optoelectronic Device for High-Speed Data Transfer"

Fig. 15.

Ledentsov. "Optoelectronic Device for High-Speed Data Transfer"

Fig. 16.

Ledentsov. "Optoelectronic Device for High-Speed Data Transfer"

Fig. 17

Ledentsov. "Optoelectronic Device for High-Speed Data Transfer"

(a)     Second Bragg Reflector is switched to a non-transparent state

(b)

(c)     Second Bragg Reflector is switched to a transparent state

(d)

Fig. 18

Ledentsov. "Optoelectronic Device for High-Speed Data Transfer"

Fig. 19

Ledentsov. "Optoelectronic Device for High-Speed Data Transfer"

Fig. 20

Ledentsov. "Optoelectronic Device for High-Speed Data Transfer"

Fig. 21

Ledentsov. "Optoelectronic Device for High-Speed Data Transfer"

Fig.22

Ledentsov. "Optoelectronic Device for High-Speed Data Transfer"

Fig.23.

Ledentsov. "Optoelectronic Device for High-Speed Data Transfer"

Fig.24

Ledentsov. "Optoelectronic Device for High-Speed Data Transfer"

Fig.25.

Ledentsov. "Optoelectronic Device for High-Speed Data Transfer"

Fig.26.

Ledentsov. "Optoelectronic Device for High-Speed Data Transfer"

Fig.27.

Ledentsov. "Optoelectronic Device for High-Speed Data Transfer"

Fig.28

Ledentsov. "Optoelectronic Device for High-Speed Data Transfer"

Fig.29

Ledentsov. "Optoelectronic Device for High-Speed Data Transfer"

Fig.30

Ledentsov. "Optoelectronic Device for High-Speed Data Transfer"

Fig.31

Fig.32

Ledentsov. "Optoelectronic Device for High-Speed Data Transfer"

Fig.33

Ledentsov. "Optoelectronic Device for High-Speed Data Transfer"

Fig. 34

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 11453979 B
- US 60814054 B
- US 7031360 B
- US 10943044 B
- US 09936005 A
- US 6285704 B
- US 5574738 A
- US 6396083 B
- US 6611539 B
- US 7075954 B
- US 14448205 A
- US 11144482 B
- EP 0618651 A2
- US 6865214 B
- US 11099360 B, Ledentsov, N., Shchukin, V.
- US 11194181 B, Ledentsov, N., Shchukin, V.

### Non-patent literature cited in the description

- **I. GALBRAITH ; B. RYVKIN.** Empirical determination of the electroabsorption coefficient in semiconductors. *J. Appl. Phys.,* 1993, vol. 74, 4145
- **D.S. CHELMA et al.** Room Temperature Excitonic Nonlinear Absorption and Refraction in GaAs/AlGaAs Multiple Quantum Well Structures. *IEEE Journal of Quantum Electronics,* 1984, vol. QE-20 (3), 265-275
- **J.E. ZUCKER ; T.L. HENDRICKSON ; C.A. BURRUS.** Electro-optic phase modulation in GaAs/AlGaAs quantum well waveguides. *Applied Physics Letters,* 1988, vol. 52 (12), 945-947
- **J.S. WEINER et al.** Quadratic electro-optic effect due to the quantum-confined Stark effect in quantum wells. *Applied Physics Letters,* 1987, vol. 50 (13), 842-844
- **J.E. ZUCKER et al.** Quaternary quantum wells for electro-optic intensity and phase modulation at 1.3 and 1.55 $\mu$m. *Applied Physics Letters,* 1989, vol. 54 (1), 10-12
- **M.P. EARNSHOW ; D.W.E. ALLSHOP.** Electrooptic Effects in GaAs-AlGaAs Narrow Coupled Quantum Wells. *IEEE Journal of Quantum Electronics,* vol. 37 (7), 897-904
- *IEEE JOURNAL OF QUANTUM ELECTRONICS,* 2001, vol. 37 (8), 1103
- **L. CHEN ; K.C. RAJKUMAR ; A. MADHUKAR.** Optical Absorption and Modulation Behavior of Strained InxGal-xAs/GaAs (100) (x $\leq$ 0.25) multiple quantum well structure grown via molecular beam epitaxy. *Applied Physics Letters,* 1990, vol. 57 (23), 2478-2480
- **FENG et al.** Exciton energies as a function of electric field: Confined quantum Stark effect. *Physical Review B,* 1993, vol. 48 (3), 1963-1966
- **A. YARIV ; P. YEH.** Optical Waves in Crystals. Propagation and Control of Laser Radiation. Wiley, 1984
- Vertical-Cavity Surface-Emitting Lasers: Design, Fabrication, Characterization, and Applications. Cambridge University Press, 1999, 193-232
- **GALBRAITH, B. RYVKIN.** Empirical determination of the electroabsorption coefficient in semiconductors. *Journal of Applied Physics,* 1993, vol. 74, 4145
- **S. CHELMA et al.** Room Temperature Excitonic Nonlinear Absorption and Refraction in GaAs/AlGaAs Multiple Quantum Well Structures. *IEEE Journal of Quantum Electronics,* 1984, vol. QE-20 (3), 265-275
- **J.E. ZUCKER ; T.L. HENDRICKSON ; C.A. BURRUS.** Electro-optic phase modulation in GaAs/AlGaAs quantum well waveguides. *Applied Physics Letters,* 1988, vol. 52, 945-947
- **J.S. WEINER ; D.A.B. MILLER ; D.S. CHEMLA.** Quadratic electro-optic effect due to the quantum-confined Stark effect in quantum wells. *Applied Physics Letters,* 1987, vol. 50 (13), 842-844
- **J.E. ZUCKER ; BAR-JOSEPH ; B.I. MILLER ; U. KOREN ; D.S. CHEMLA.** Quaternary quantum wells for electro-optic intensity and phase modulation at 1.3 and 1.55 $\mu$m. *Applied Physics Letters,* 1989, vol. 54 (1), 10-12
- **P. EARNSHOW ; D.W.E. ALISHOP.** Electrooptic Effects in GaAs-AlGaAs Narrow Coupled Quantum Wells. *IEEE Journal of Quantum Electronics,* vol. 37 (7), 897-904

- **CHEN, K.C. RAJKUMAR ; A. MADHUKAR.** Optical Absorption and Modulation Behavior of Strained In-xGa1-xAs/GaAs (100) (x ≤ 0.25 ) multiple quantum well structure grown via molecular beam epitaxy. *Applied Physics Letters,* 1990, vol. 57 (23), 2478-2480
- **YU.-P. FENG ; H.N. SPECTOR.** Exciton energies as a function of electric field: Confined quantum Stark effect. *Physical Review B,* 1993, vol. 48 (3), 1963-1966
- **W. BATTY ; D.W.E. ALLSOPP.** Internal biasing by δ-doping for low-voltage, high-bandwidth quantum well optical modulators. *IEEE Photonics Technology Letters,* 1995, vol. 7 (6), 635-637
- **H. FENG ; J.P. PANG ; M. SUGIYAMA ; K. TADA ; Y. NAKANO.** Field-induced optical effect in a five-step asymmetric coupled quantum well with modified potential. *IEEE Journal of Quantum Electronics,* 1998, vol. 34 (7), 1197-1208
- **G. LENGEL ; K.W.JELLEY ; R.W.H. ENGELMANN.** A Semi-Empirical Model for Electroabsorption in GaAs/AlGaAs Multiple Quantum Well Modulator structures. *EEE Journal of Quantum Electronics,* 1990, vol. 74 (2), 296-304
- **T. SUZUKI ; T. ARAKAWA ; K. TADA ; YU. IMAZATO ; J.-H. NOH ; N. HANEJI.** Observation of giant electrorefractive effect in five-layer asymmetric coupled quantum wells (FACQWs. *Japanese Journal of Applied Physics,* 2004, vol. 43, L1540-L 1542
- **V. KOTLYAR ; L. O'FAOLAIN ; A.B. KRYSA ; TH.F. KRAUSS.** Electrooptic Tuning of InP-Based Microphotonic Fabry-Pérot Filters. *Journal of Lightwave Technology,* 2005, vol. 23 (6), 2369-2374
- **H.C. CASEY, JR. ; M.B. PANISH.** Heterostructure Lasers, Part A. Academic Press, 1978, 34-57
- Vertical-Cavity Surface-Emitting Lasers: Design, Fabrication. Characterization. and Applications. Cambridge University Press, 1999, 193-232
- **N.N. LEDENTSOV ; V.A. SHCHUKIN.** Novel concepts for injection lasers. *SPIE Optical Engineering,* 2002, vol. 41 (12), 3193-3203
- **N. LEDENTSOV ; V.A. SHCHUKIN ; S.S. MIKHRIN ; I.L. KRESTNIKOV ; A.V. KOZHUKHOV ; A.R. KOVSH ; L.YA. KARACHINSKY ; M.V. MAXIMOV ; I.I. NOVIKOV ; YU.M. SHEMYAKOV.** Wavelength-stabilized tilted cavity quantum dot laser. *Semiconductor. Science.and Technology,* 2004, vol. 19, 1183-1188
- Tilted Cavity Laser. **A. SHCHUKIN ; N.N. LEDENTSOV ; S.S. MIKHRIN ; I.L. KRESTNIKOV ; A.V. KOZHUKHOV ; A.R. KOVSH ; L.YA. KARACHINSKY ; M.V. MAXIMOV ; I.I. NOVIKOV ; YU.M. SHEMYAKOV.** Nanomodeling. 2004, 61-71
- **N.N. LEDENTSOV ; V.A. SHCHUKIN ; A.R. KOVSH ; S.S. MIKHRIN ; I.L. KRESTNIKOV ; A.V. KOZHUKHOV ; N.YU. GORDEEV ; L.YA. KARACHINSKY ; M.V. MAXIMOV ; I.I. NOVIKOV.** Edge and Surface-Emitting Tilted Cavity Lasers. *Proceedings. SPIE,* 2005, vol. 5722, 130-146
- **A. SHCHUKIN ; N.N. LEDENTSOV ; N.YU. GORDEEVB ; L.YA. KARACHINSKY ; N.V. KRYZHANOVSKAYA ; S.M. KUZNETSOVB ; M.B. LIFSHITS ; M.V. MAXIMOV ; I.I. NOVIKOV ; YU.M. SHERNYAKOV.** High brilliance photonic band crystal laser. *Proc. SPIE,* 2006, vol. 6350, 635005-1635005-15
- **B. LIFSHITS ; V.A. SHCHUKIN ; N.N. LEDENTSOV ; D. BIMBERG.** Resonance wavelength in planar multilayer waveguides: control and complete suppression of temperature sensitivity. *Semiconductor Science and Technology,* 2007, vol. 22, 380-384